# EUROPEAN PATENT APPLICATION

(11) **EP 4 694 653 A2**
(43) Date of publication of application: **11.02.2026**
(21) Application number: 25182992.5
(22) Date of filing: 16.06.2025
(51) Int. Cl.: H10K 59/80

(54) **DISPLAY DEVICE, ADHESIVE MEMBER FORMING APPARATUS FOR DISPLAY DEVICE, ELECTRONIC DEVICE INCLUDING DISPLAY DEVICE, AND METHOD OF MANUFACTURING DISPLAY DEVICE**

(30) Priority: 01.07.2024 KR 20240086294
(71) Applicant: Samsung Display Co., Ltd., Yongin-si, Gyeonggi-do 17113 (KR)
(72) Inventor: LEE, Sang Moo, Giheung-gu, Yongin-si, Gyeonggi-do (KR); KIM, Byeong Hyun, Giheung-gu, Yongin-si, Gyeonggi-do (KR); KIM, Gyu Tae, Giheung-gu, Yongin-si, Gyeonggi-do (KR); LEE, Sang Hyuk, Giheung-gu, Yongin-si, Gyeonggi-do (KR)
(74) Representative: Dr. Weitzel & Partner

(57) **Abstract**

A display device includes a substrate (SUB); a pixel electrode (PXE) on the substrate; a light-emitting layer (EL) on the pixel electrode; a common electrode (CE) on the light-emitting layer; an encapsulation layer (TFE) on the common electrode; a polarizing layer (POL) on the encapsulation layer; an adhesive member (ADL) on the polarizing layer; a cover window (CSUB) on the adhesive member; and a light blocking layer (BM) disposed next (adjacent) to the adhesive member, between the polarizing layer and the cover window, wherein an angle (θ**1**) defined between a side surface of the adhesive member facing the light blocking layer and a top surface of the adhesive member facing the cover window is 90 degrees to 135 degrees.

## Description

### BACKGROUND

### 1. Field

The invention relates to a display device capable of improving image quality, an adhesive member forming apparatus for the display device, and a method of manufacturing the display device.

### 2. Description of the Related Art

Since an organic light-emitting diode ("OLED") display is self-emissive and does not desire a separate light source unlike a liquid crystal display, its thickness and weight may be reduced. In addition, (an organic light-emitting diode ("OLED") display has garnered attention as a next-generation display for televisions ("TVs"), monitors, and portable electronic devices due to its superior characteristics such as relatively low power consumption, relatively high luminance, and relatively high response speed.

### SUMMARY

Features of the invention provide a display device capable of improving image quality, an adhesive member forming apparatus for the display device, and a method of manufacturing the display device.

The invention is defined by the independent claims. In an embodiment of the invention, there is provided a display device comprising: a substrate; a pixel electrode on the substrate; a light-emitting layer on the pixel electrode; a common electrode on the light-emitting layer; an encapsulation layer on the common electrode; a polarizing layer on the encapsulation layer; an adhesive member on the polarizing layer; a cover window on the adhesive member; and a light blocking layer disposed next (adjacent) to the adhesive member, between the polarizing layer and the cover window, wherein an angle defined between a side surface of the adhesive member facing the light blocking layer and a top surface of the adhesive member facing the cover window is 90 degrees to 135 degrees.

In an embodiment of the invention, there is provided an adhesive member forming apparatus for a display device, comprising: a guide rail; a stage moving along the guide rail, on the guide rail; an alignment device which aligns a substrate on the stage; a curing device which cures an adhesive member of the substrate; an inkjet printing device disposed between the alignment device and the curing device, and providing a raw material of the adhesive member onto the substrate; and a printing pattern providing device providing a first printing pattern corresponding to an intermediate adhesive layer of the adhesive member, and a second printing pattern corresponding to a first peripheral adhesive layer of the adhesive member and a second peripheral adhesive layer of the adhesive member.

In an embodiment of the invention, there is provided a method of manufacturing a display device, comprising: forming, on a substrate, an intermediate adhesive layer surrounding a display area of the substrate; curing the intermediate adhesive layer; forming a first peripheral adhesive layer and a second peripheral adhesive layer on a first side surface and a second side surface of the intermediate adhesive layer, respectively; and curing the intermediate adhesive layer, the first peripheral adhesive layer, and the second peripheral adhesive layer.

According to the display device, the adhesive member forming apparatus for the display device, and the method of manufacturing the display device according to the invention, the top surface of the edge of an adhesive member may be flattened. Accordingly, the adhesion between the adhesive member and a cover window at the edge of the adhesive member may be improved. Accordingly, a gap (e.g., an air gap) may be prevented from being defined between the adhesive member and the cover window at the edge of the adhesive member. As a result, spot defects may be prevented from being visually recognized around the edge of the adhesive member, so that the image quality of the display device may be improved.

The effects of the invention are not limited to the above-described effects and other effects which are not described herein will become apparent to those skilled in the art from the following description.

### BRIEF DESCRIPTION OF THE DRAWINGS

The above and other advantages and features of the invention will become more apparent by describing in detail embodiments thereof with reference to the attached drawings, in which:
FIG. 1 is a perspective view illustrating an embodiment of a display device;
FIG. 2 is a layout diagram illustrating an embodiment of a display panel;
FIG. 3 is a block diagram illustrating an embodiment of a display device;
FIG. 4 is an equivalent circuit diagram illustrating an embodiment of a pixel;
FIG. 5 is a layout diagram showing in detail an embodiment of the display area of FIG. 2;
FIG. 6 is a cross-sectional view of the display panel taken along line II-II' of FIG. 5;
FIG. 7 is a cross-sectional view of the display panel taken along line I-I' of FIG. 2;
FIG. 8 is a schematic plan view of an embodiment of the display panel including an adhesive layer;
FIG. 9 is a cross-sectional view taken along line III-III' of FIG. 8;
FIG. 10 is a schematic plan view of an embodiment of the display panel including an adhesive layer;
FIG. 11 is a cross-sectional view taken along line IV-IV' of FIG. 10;
FIG. 12 is a schematic diagram of an embodiment of an adhesive member forming apparatus for the display device;
FIG. 13 is a cross-sectional view taken along line V-V' of FIG. 12;
FIGS. 14 to 31 are diagrams for describing an embodiment of a method of manufacturing a display device;
FIG. 32 is a plan view of the substrate disposed on the stage in FIGS. 16 to 21;
FIG. 33 is a cross-sectional view taken along line VI-VI' in FIG. 32;
FIG. 34 is a cross-sectional view of the substrate disposed on the stage in FIGS. 26 to 31;
FIG. 35 is a schematic plan view of an embodiment of the display panel including the adhesive member;
FIG. 36 is a cross-sectional view taken along line VII-VII' of FIG. 35;
FIG. 37 is a schematic plan view of an embodiment of the display panel including the adhesive member;
FIG. 38 is a cross-sectional view taken along line VIII-VIII' of FIG. 37;
FIG. 39 is a schematic plan view of an embodiment of the display panel including the adhesive member;
FIG. 40 is a schematic plan view of an embodiment of the display panel including the adhesive member;
FIG. 41 is a block diagram illustrating an electronic device according to an embodiment; and
FIG. 42 is a view illustrating an embodiment of the electronic device of FIG. 41 implemented as a smartphone.

### DETAILED DESCRIPTION

Embodiments of the invention will now be described more fully hereinafter with reference to the accompanying drawings, in which preferred embodiments of the invention are shown. This invention may, however, be embodied in different forms and should not be construed as limited to the embodiments set forth herein. Rather, these embodiments are provided so that this invention will be thorough and complete, and will fully convey the scope of the invention to those skilled in the art.

It will also be understood that when a layer is referred to as being "on" another layer or substrate, it may be directly on the other layer or substrate, or intervening layers may also be present. The same reference numbers indicate the same components throughout the specification. In the attached drawing figures, the thickness of layers and regions is exaggerated for clarity.

Although the terms "first", "second", etc. may be used herein to describe various elements, these elements, should not be limited by these terms. These terms may be used to distinguish one element from another element. Thus, a first element discussed below may be termed a second element without departing from teachings of embodiments. The description of an element as a "first" element may not require or imply the presence of a second element or other elements. The terms "first", "second", etc. may also be used herein to differentiate different categories or sets of elements. For conciseness, the terms "first", "second", etc. may represent "first-category (or first-set)", "second-category (or second-set)", etc., respectively.

Features of various embodiments of the invention may be combined partially or totally. As will be clearly appreciated by those skilled in the art, technically various interactions and operations are possible. Various embodiments may be practiced individually or in combination.

Hereinafter, predetermined embodiments will be described with reference to the accompanying drawings.

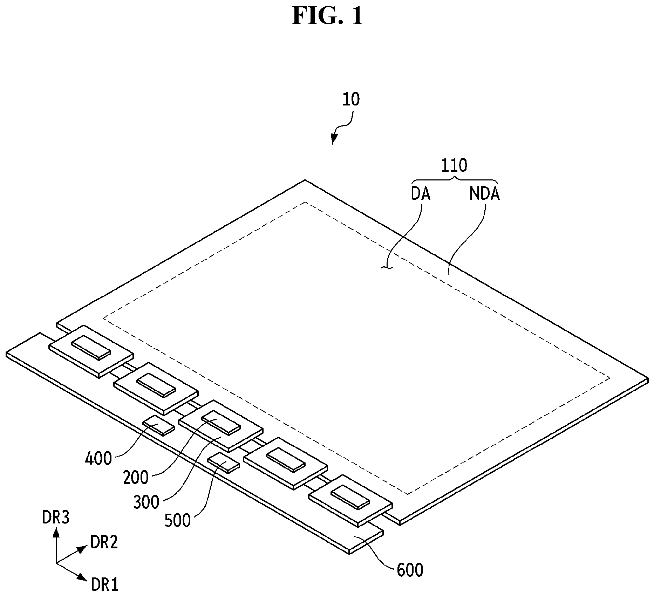

FIG. 1 is a perspective view illustrating an embodiment of a display device.

Referring to FIG. 1, a display device 10 is a device for displaying a moving image or a still image. The display device 10 may be used as a display screen of various devices, such as a television, a laptop computer, a monitor, a billboard and an Internet-of-Things ("IoT") device, as well as portable electronic devices such as a mobile phone, a smartphone, a tablet personal computer ("PC"), a smart watch, a watch phone, a mobile communication terminal, an electronic notebook, an electronic book, a portable multimedia player ("PMP"), a navigation device and an ultra-mobile PC ("UMPC").

The display device 10 may be a light-emitting display device such as an organic light-emitting display using an organic light-emitting diode, a quantum dot light-emitting display including a quantum dot light-emitting layer, an inorganic light-emitting display including an inorganic semiconductor, and a micro light-emitting display using a micro or nano light-emitting diode ("LED"). In the following description, it is assumed that the display device 10 is an organic light-emitting display device, but the invention is not limited thereto.

The display device 10 includes a display panel 100, a plurality of source driving circuits 200, a plurality of flexible circuit boards 300, a timing control circuit 400, a power supply circuit 500, and a circuit board 600.

The display panel 100 may, in a plan view, be formed in a quadrangular shape, e.g., rectangular shape having long sides in a first direction DR1 and short sides in a second direction DR2 crossing the first direction DR1. The corner where the long side in the first direction DR1 and the short side in the second direction DR2 meet may be rounded to have a predetermined curvature or may be right-angled. The planar shape of the display panel 100 is not limited to the quadrangular shape, e.g., rectangular shape, and may be formed in another polygonal shape, a circular shape or an elliptical shape. The display panel 100 may be flat, but is not limited thereto. In an embodiment, the display panel 100 may include a curved portion formed at left and right ends and having a constant curvature or a varying curvature, for example. In addition, the display panel 100 may be formed flexibly so that it may be curved, bent, folded, or rolled.

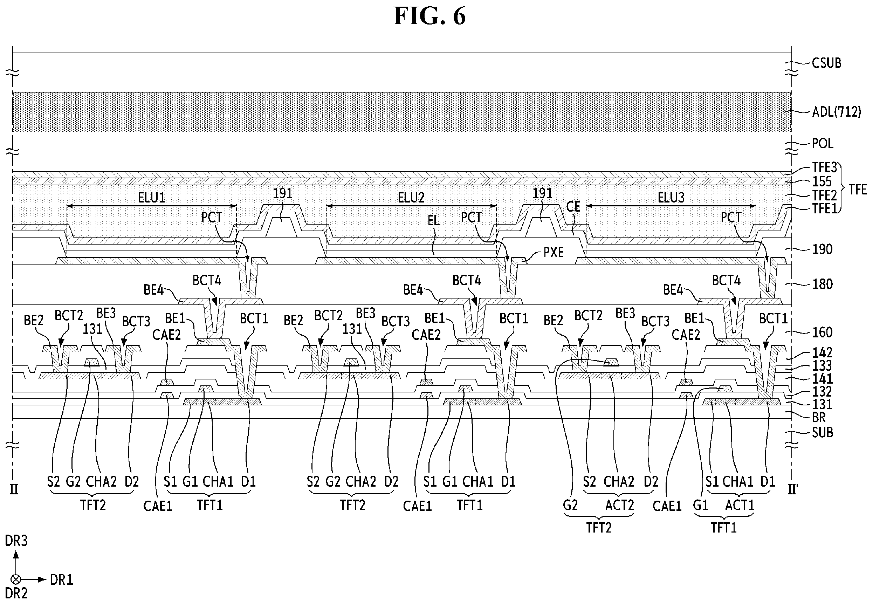

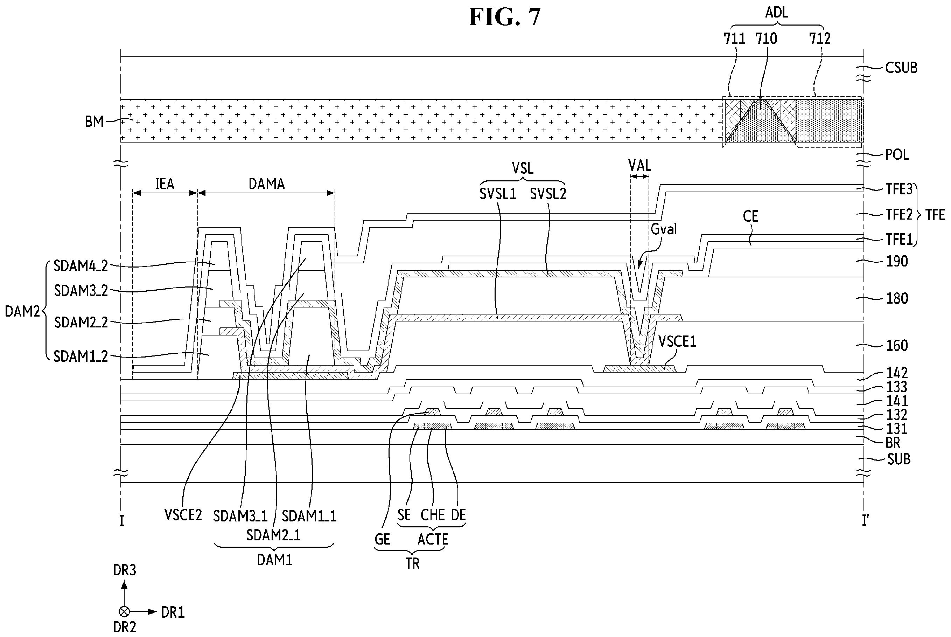

The display panel 100 may include a display area DA displaying an image and a non-display area NDA disposed around the display area DA. A substrate (e.g., SUB in FIGS. 6 and 7) of the display panel 100 may include the display area DA and the non-display area NDA.

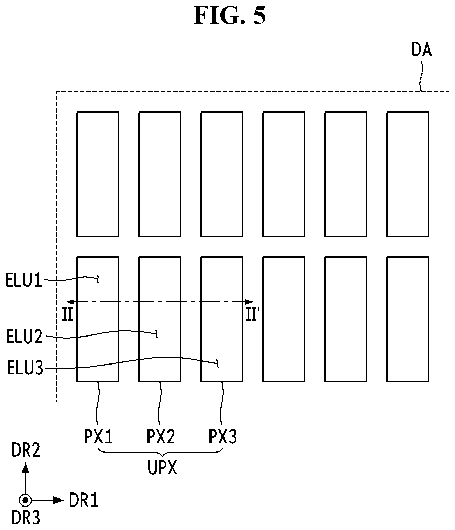

The display area DA may occupy most of the area of the display panel 100. The display area DA may be disposed at the center of the display panel 100. A plurality of pixels PX (refer to FIG. 5) may be disposed in the display area DA to display an image.

The non-display area NDA may be an area that does not display an image. The non-display area NDA may be an edge area of the display panel 100. The non-display area NDA may be an area outside the display area DA. The non-display area NDA may be disposed to surround the display area DA.

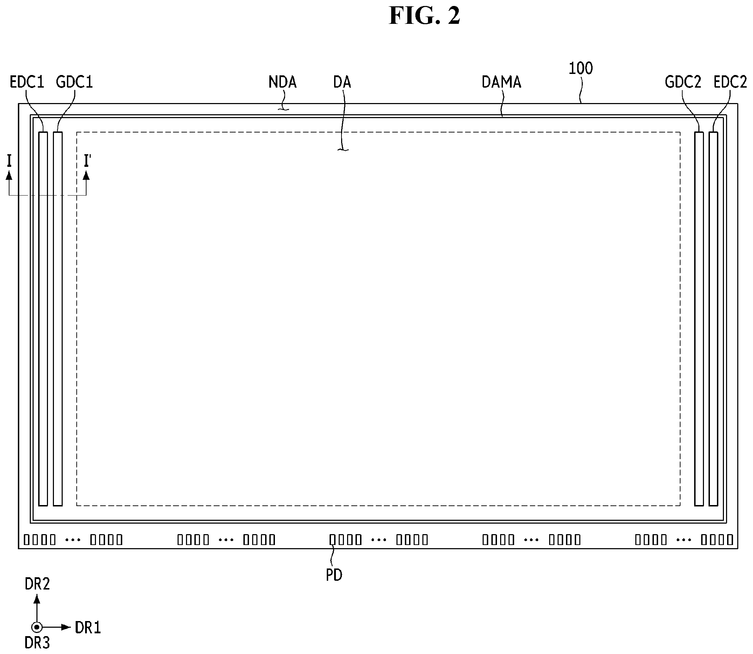

Display pads PD (refer to FIG. 2) may be disposed in the non-display area NDA to be connected to the plurality of flexible circuit boards 300. The display pads PD (refer to FIG. 2) may be disposed on one side edge of the display panel 100.

Each of the source driving circuits 200 may be formed as an integrated circuit ("IC") and attached to the flexible circuit board 300 corresponding thereto, but the invention is not limited thereto. Each of the source driving circuits 200 may be attached onto the display panel 100 by a chip on glass ("COG") method, a chip on plastic ("COP") method, or an ultrasonic bonding method.

Each of the plurality of flexible circuit boards 300 may be disposed on the display pads PD (refer to FIG. 2) disposed on one side edge of the display panel 100. Each of the plurality of flexible circuit boards 300 may be attached to the display pads PD (refer to FIG. 2) using a conductive adhesive member such as an anisotropic conductive film. Accordingly, the plurality of flexible circuit boards 300 may be electrically connected to the signal lines of the display panel 100. The plurality of flexible circuit boards 300 may be a flexible printed circuit board or a flexible film such as a chip on film.

The timing control circuit 400 may generate timing control signals for controlling the timing of scan driving circuits GDC1 and GDC2 (refer to FIG. 2), emission driving circuits EDC1 and EDC2 (refer to FIG. 2), and the source driving circuit 200. The power supply circuit 500 may generate a plurality of power voltages for driving the display panel 100 according to an input power inputted from the outside. Each of the timing control circuit 400 and the power supply circuit 500 may be formed as an integrated circuit ("IC") and attached to the circuit board 600.

The circuit board 600 may be connected to one side of each of the plurality of flexible circuit boards 300. The circuit board 600 may be a rigid printed circuit board.

FIG. 2 is a layout diagram illustrating an embodiment of a display panel.

Referring to FIG. 2, the display panel 100 may include the display pads PD, a first scan driving circuit GDC1, a first emission driving circuit EDC1, a second scan driving circuit GDC2, a second emission driving circuit EDC2, and a dam area DAMA.

The display pads PD may be disposed on one side edge of the display panel 100. The display pads PD may be distinguished into a plurality of groups. When the display device 10 includes the five flexible circuit boards 300 as illustrated in FIG. 1, the display pads PD may be distinguished into five groups. The display pads PD of each of the plurality of groups may correspond to bumps of the flexible circuit board 300 corresponding thereto on a one-to-one basis. Accordingly, the display pads PD of each of the plurality of groups may be electrically connected to the flexible circuit board 300 corresponding thereto.

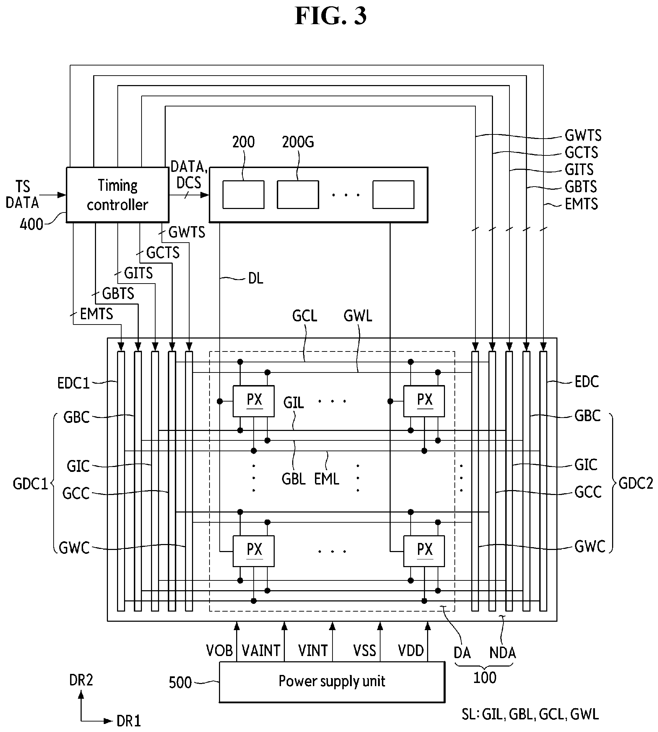

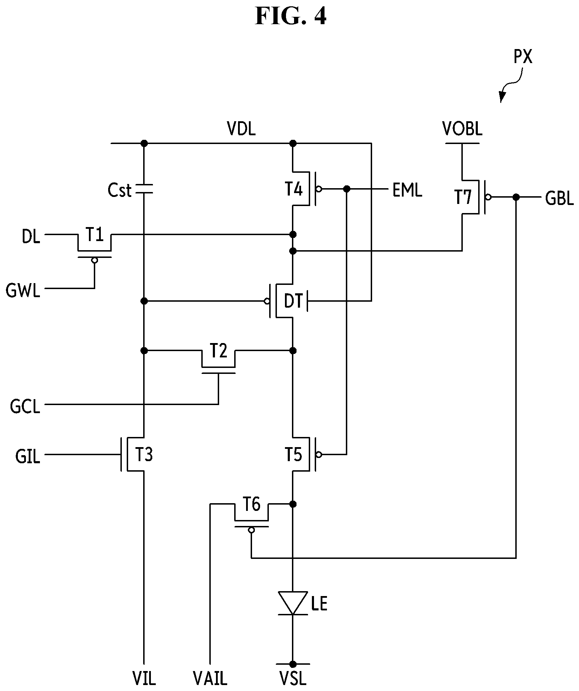

Some of the display pads PD may be electrically connected to data lines DL (refer to FIG. 3) disposed in the display area DA. Yet some others of the display pads PD may be electrically connected to the first scan driving circuit GDC1, the second scan driving circuit GDC2, the first emission driving circuit EDC1, and the second emission driving circuit EDC2. Yet some others of the display pads PD may be connected to a first power line VSL (refer to FIG. 4) to which a first power voltage is applied.

The first power line VSL may be disposed to surround at least three sides of the display area DA. In an embodiment, the first power line VSL may be disposed to surround the left side, upper side, and right side of the display area DA, for example. In an alternative embodiment, the first power line VSL may be disposed to surround the left side, upper side, right side, and lower side of the display area DA.

The first scan driving circuit GDC1 and the second scan driving circuit GDC2 may be electrically connected to scan lines GIL, GCL, GWL, GBL (refer to FIG. 3) of the display area DA. The first scan driving circuit GDC1 may be disposed in the non-display area NDA on the first side (e.g., left side) of the display panel 100. The second scan driving circuit GDC2 may be disposed in the non-display area NDA on the second side (e.g., right side) of the display panel 100.

The first emission driving circuit EDC1 and the second emission driving circuit EDC2 may be electrically connected to emission control lines EML (refer to FIG. 3) of the display area DA. The first emission driving circuit EDC1 may be disposed in the non-display area NDA on the first side (e.g., left side) of the display panel 100. The second emission driving circuit EDC2 may be disposed in the non-display area NDA on the second side (e.g., right side) of the display panel 100.

The first scan driving circuit GDC1 may be disposed between the display area DA and the first emission driving circuit EDC1. The first scan driving circuit GDC1 may be disposed closer to the display area DA than the first emission driving circuit EDC1. Additionally, the first emission driving circuit EDC1 may be disposed closer to the first side edge of the display panel 100 than the first scan driving circuit GDC1.

The second scan driving circuit GDC2 may be disposed between the display area DA and the second emission driving circuit EDC2. The second scan driving circuit GDC2 may be disposed closer to the display area DA than the second emission driving circuit EDC2. Additionally, the second emission driving circuit EDC2 may be disposed closer to the second side edge of the display panel 100 than the second scan driving circuit GDC2.

The dam area DAMA may include at least one dam DAM1 and DAM2 (refer to FIG. 7) to prevent an organic encapsulation layer TFE2 (refer to FIG. 7) from overflowing into the display pads PD. The dam area DAMA may be disposed to surround the display area DA.

The dam area DAMA may be disposed outside the first emission driving circuit EDC1 and outside the second emission driving circuit EDC2. The dam area DAMA may be disposed closer to the first side edge of the display panel 100 than the first emission driving circuit EDC1. Additionally, the dam area DAMA may be disposed closer to the second side edge of the display panel 100 than the second emission driving circuit EDC2.

FIG. 3 is a block diagram illustrating an embodiment of a display device.

Referring to FIG. 3, the display area DA may include the plurality of pixels PX, a plurality of scan lines SL, a plurality of emission control lines EML, and a plurality of data lines DL.

The plurality of pixels PX may be arranged in a matrix form in the first direction DR1 and the second direction DR2. The plurality of scan lines SL and the plurality of emission control lines EML may extend in the first direction DR1, while being arranged in the second direction DR2. The plurality of data lines DL may extend in the second direction DR2, while being arranged in the first direction DR1. The plurality of scan lines SL include a plurality of write scan lines GWL, a plurality of control scan lines GCL, a plurality of initialization scan lines GIL, and a plurality of bias scan lines GBL.

Each of the plurality of pixels PX may be connected to any one write scan line GWL among the plurality of write scan lines GWL, any one control scan line GCL among the plurality of control scan lines GCL, any one initialization scan line GIL among the plurality of initialization scan lines GIL, any one bias scan line GBL among the plurality of bias scan lines GBL, any one emission control line EML among the plurality of emission control lines EML, and any one data line DL among the plurality of data lines DL. Each of the plurality of pixels PX may receive the data voltage of the data line DL according to the write scan signal of the write scan line GWL, and may emit light from a light-emitting element thereof according to the data voltage.

The non-display area NDA includes the first scan driving circuit GDC 1, the second scan driving circuit GDC2, the first emission driving circuit EDC1, and the second emission driving circuit EDC2.

Each of the first scan driving circuit GDC1 and the second scan driving circuit GDC2 may include a write scan driving circuit GWC, a control scan driving circuit GCC, an initialization scan driving circuit GIC, and a bias scan driving circuit GBC. FIG. 3 illustrates that the write scan driving circuit GWC, the control scan driving circuit GCC, the initialization scan driving circuit GIC, and the bias scan driving circuit GBC are sequentially disposed from the display area DA to the edge of the display panel 100, but the invention is not limited thereto.

The write scan driving circuit GWC may receive a write timing signal GWTS from the timing control circuit 400. The write scan driving circuit GWC may generate write scan signals according to the write timing signal GWTS and sequentially output them to the write scan lines GWL.

The control scan driving circuit GCC may receive a control timing signal GCTS from the timing control circuit 400. The control scan driving circuit GCC may generate control scan signals according to the control timing signal GCTS and sequentially output them to the control scan lines GCL.

The initialization scan driving circuit GIC may receive an initialization timing signal GITS from the timing control circuit 400. The initialization scan driving circuit GIC may generate initialization scan signals according to the initialization timing signal GITS and sequentially output them to the initialization scan lines GIL.

The bias scan driving circuit GBC may receive a bias timing signal GBTS from the timing control circuit 400. The bias scan driving circuit GBC may generate bias scan signals according to the bias timing signal GBTS and sequentially output them to the bias scan lines GBL.

Each of the first emission driving circuit EDC1 and the second emission driving circuit EDC2 may receive an emission timing signal EMTS from the timing control circuit 400. Each of the first emission driving circuit EDC1 and the second emission driving circuit EDC2 may generate emission control signals according to the emission timing signal EMTS and sequentially output them to the emission control lines EML.

A data driving circuit 200G includes the plurality of source driving circuits 200. Each of the plurality of source driving circuits 200 may receive digital video data DATA and a data timing signal DCS from the timing control circuit 400. Each of the plurality of source driving circuits 200 converts the digital video data DATA into analog data voltages according to the data timing signal DCS and outputs them to the data lines DL. In this case, the pixels PX may be selected by the write scan signal, and data voltages may be supplied to the selected pixels PX.

The timing control circuit 400 may receive the digital video data DATA and timing signals TS from the outside. A timing control circuit 251 may generate the write timing signal GWTS, the control timing signal GCTS, the initialization timing signal GITS, the bias timing signal GBTS, and the emission timing signal EMTS according to the timing signals TS. The timing control circuit 400 may output the write timing signal GWTS to the write scan driving circuits GWC and may output the control timing signal GCTS to the control scan driving circuits GCC. Additionally, the timing control circuit 400 may output the initialization timing signal GITS to the initialization scan driving circuits GIC and may output the bias timing signal GBTS to the bias scan driving circuits GBC. The timing control circuit 400 may output the emission timing signal EMTS to the first emission driving circuit EDC1 and the second emission driving circuit EDC2. Additionally, the timing control circuit 400 may output the digital video data DATA and the data timing signal DCS to the source driving circuits 200.

The power supply circuit 500 may generate a plurality of panel driving voltages according to a power voltage from the outside. In an embodiment, the power supply circuit 500 may generate a first power voltage VSS, a second power voltage VDD, a third power voltage VINT, a fourth power voltage VAINT, and a fifth power voltage VOB and supply them to the display panel 100, for example. The first power voltage VSS may be a relatively low potential voltage, and the second power voltage VDD may be a relatively high potential voltage. The third power voltage VINT may be a first initialization voltage, the fourth power voltage VAINT may be a second initialization voltage, and the fifth power voltage VOB may be a third initialization voltage. The third power voltage VINT, the fourth power voltage VAINT, and the fifth power voltage VOB may be a voltage higher than the first power voltage VSS and lower than the second power voltage VDD.

FIG. 4 is an equivalent circuit diagram illustrating an embodiment of a pixel.

Referring to FIG. 4, the pixel PX in an embodiment may be connected to the write scan line GWL, the initialization scan line GIL, the control scan line GCL, the bias scan line GBL, the emission control line EML, and the data line DL.

The pixel PX in an embodiment includes a driving transistor DT, switch elements, a capacitor Cst, and a light-emitting element LE. The switch elements may include first to seventh transistors T1, T2, T3, T4, T5, T6, and T7.

The driving transistor DT controls a source-drain current (hereinafter, also referred to as "driving current") according to the data voltage applied to the first gate electrode. The second gate electrode of the driving transistor DT may be connected to the second power line VDL to which the second power voltage VDD (refer to FIG. 3) is applied.

The light-emitting element LE may be an organic light-emitting diode. The light-emitting element LE emits light by the driving current. A light emission amount of the light-emitting element LE may be proportional to the driving current. The first electrode of the light-emitting element LE may be connected to the first electrode of the fifth transistor T5 and the second electrode of the sixth transistor T6. The second electrode of the light-emitting element LE may be connected to the first power line VSL to which the first power voltage is applied. The first electrode of the light-emitting element LE may be an anode electrode or a pixel electrode, and the second electrode thereof may be a cathode electrode or a common electrode.

The first transistor T1 is turned on by the write scan signal of the gate-on voltage applied to the write scan line GWL and connects the data line DL to the first electrode of the driving transistor DT. Accordingly, the data voltage may be applied to the first electrode of the driving transistor DT while the first transistor T1 is turned on. The gate electrode of the first transistor T1 may be connected to the write scan line GWL, the first electrode thereof may be connected to the data line DL, and the second electrode thereof may be connected to the first electrode of the driving transistor DT.

The second transistor T2 is turned on by the control scan signal of the gate-on voltage applied to the control scan line GCL and connects the second electrode and the gate electrode of the driving transistor DT. While the second transistor T2 is turned on, the driving transistor DT may operate like a diode. The gate electrode of the second transistor T2 may be connected to the control scan line GCL, the first electrode thereof may be connected to the second electrode of the driving transistor DT, and the second electrode thereof may be connected to the gate electrode of the driving transistor DT.

The third transistor T3 is turned on by the initialization scan signal of the gate-on voltage applied to the initialization scan line GIL and connects the gate electrode of the driving transistor DT to the third power line VIL. While the third transistor T3 is turned on, the gate electrode of the driving transistor DT may be initialized to the third power voltage VINT (refer to FIG. 3) of the third power line VIL. The gate electrode of the third transistor T3 may be connected to the initialization scan line GIL, the first electrode thereof may be connected to the gate electrode of the driving transistor DT, and the second electrode thereof may be connected to the third power line VIL.

The fourth transistor T4 is turned on by the emission control signal of the gate-on voltage applied to the emission control line EML and connects the second power line VDL to the first electrode of the driving transistor DT. While the fourth transistor T4 is turned on, the second power voltage VDD (refer to FIG. 3) of the second power line VDL may be applied to the first electrode of the driving transistor DT. The gate electrode of the fourth transistor T4 may be connected to the emission control line EML, the first electrode thereof may be connected to the second power line VDL, and the second electrode thereof may be connected to the first electrode of the driving transistor DT.

The fifth transistor T5 is turned on by the emission control signal of the gate-on voltage applied to the emission control line EML and connects the second electrode of the driving transistor DT to the first electrode of the light-emitting element LE. While the fifth transistor T5 is turned on, the driving current of the driving transistor DT may be supplied to the light-emitting element LE. The gate electrode of the fifth transistor T5 may be connected to the emission control line EML, the first electrode thereof may be connected to the second electrode of the driving transistor DT, and the second electrode thereof may be connected to the first electrode of the light-emitting element LE.

The sixth transistor T6 is turned on by the bias scan signal of the gate-on voltage applied to the bias scan line GBL and connects the first electrode of the light-emitting element LE to the fourth power line VAIL. While the sixth transistor T6 is turned on, the first electrode of the light-emitting element LE may be initialized to the fourth power voltage VAINT (refer to FIG. 3) of the fourth power line VAIL. The gate electrode of the sixth transistor T6 may be connected to the bias scan line GBL, the first electrode thereof may be connected to the first electrode of the light-emitting element LE, and the second electrode thereof may be connected to the fourth power line VAIL.

The seventh transistor T7 is turned on by the bias scan signal of the gate-on voltage applied to the bias scan line GBL and connects the first electrode of the driving transistor DT to the fifth power line VOBL. While the seventh transistor T7 is turned on, the first electrode of the driving transistor DT may be initialized to the fifth power voltage VOB (refer to FIG. 3) of the fifth power line VOBL. The gate electrode of the seventh transistor T7 may be connected to the bias scan line GBL, the first electrode thereof may be connected to the first electrode of the driving transistor DT, and the second electrode thereof may be connected to the fifth power line VOBL.

The capacitor Cst is formed between the gate electrode of the driving transistor DT and the second power line VDL. One electrode of the capacitor Cst may be connected to the gate electrode of the driving transistor DT, and a remaining (the other) electrode thereof may be connected to the second power line VDL.

The driving transistor DT, the first transistor T1, the fourth transistor T4, the fifth transistor T5, the sixth transistor T6, and the seventh transistor T7 may be formed as p-type metal oxide semiconductor field effect transistors (MOSFETs). In this case, the active layer of each of the driving transistor DT, the first transistor T1, the fourth transistor T4, the fifth transistor T5, the sixth transistor T6, and the seventh transistor T7 may include or consist of polysilicon. In addition, the driving transistor DT, the first transistor T1, the fourth transistor T4, the fifth transistor T5, the sixth transistor T6, and the seventh transistor T7 may be turned on by a signal of a gate relatively low voltage.

Additionally, the second transistor T2 and the third transistor T3 may be formed as n-type metal oxide semiconductor field effect transistors. In this case, the active layer of each of the second transistor T2 and the third transistor T3 may include or consist of an oxide semiconductor. Additionally, the second transistor T2 and the third transistor T3 may be turned on by a signal of a gate relatively high voltage.

FIG. 5 is a layout diagram showing in detail an embodiment of the display area of FIG. 2.

Referring to FIG. 5, a plurality of unit pixels UPX may be arranged in a matrix form. The unit pixel UPX may include a first pixel PX1, a second pixel PX2, and a third pixel PX3 that are next (adjacent) to each other.

The first pixel PX1 may provide first light through a first emission area ELU1, the second pixel PX2 may provide second light through a second emission area ELU2, and the third pixel PX3 may provide third light through a third emission area ELU3.

In an embodiment, the first light may be light of a blue wavelength band, the second light may be light of a green wavelength band, and the third light may be light of a red wavelength band. In an embodiment, the blue wavelength band is a wavelength band of light whose main peak wavelength is in the range of about 370 nanometers (nm) to about 460 nm, the green wavelength band is a wavelength band of light whose main peak wavelength is in the range of about 480 nm to about 560 nm, and the red wavelength band is a wavelength band of light whose main peak wavelength is in the range of about 600 nm to about 750 nm, for example.

FIG. 5 illustrates that a unit pixel includes three pixels, but the invention is not limited thereto. In an embodiment, the unit pixel UPX may include four or more pixels, for example. In an embodiment, when a unit pixel includes four pixels, the first emission area of the first pixel may provide the first light, each of the second emission area of the second pixel and the fourth emission area of the fourth pixel may provide the second light, and the third emission area of the third pixel may provide the third light, for example. In an alternative embodiment, the first emission area of the first pixel may provide the first light, the second emission area of the second pixel may provide the second light, the third emission area of the third pixel may provide the third light, and the fourth emission area of the fourth pixel may provide fourth light. Here, the fourth light may be white light. Additionally, in each of the plurality of pixels PX, the first emission area of the first pixel, the second emission area of the second pixel, the third emission area of the third pixel, and the fourth emission area of the fourth pixel may be arranged in a stripe shape or a Pentile^{®} shape.

FIG. 6 is a cross-sectional view of the display panel taken along line II-II' of FIG. 5. FIG. 6 illustrates a cross section of the display panel 100 illustrating the first emission area ELU1, the second emission area ELU2, and the third emission area ELU3 of the display area DA.

Referring to FIG. 6, the substrate SUB may include or consist of an insulating material such as glass or polymer resin.

A barrier film BR may be disposed on the substrate SUB. The barrier film BR is a film for protecting thin film transistors TFT1 and TFT2 and a light-emitting layer EL from moisture permeating through the substrate SUB that is susceptible to moisture permeation. The barrier film BR may be formed as a plurality of inorganic layers that are alternately stacked.

The first thin film transistor TFT1 may be disposed on the barrier film BR. The first thin film transistor TFT1 may be any one of the fifth transistor T5 and the sixth transistor T6 illustrated in FIG. 4. The first thin film transistor TFT1 may include a first active layer ACT1 and a first gate electrode G1.

The first active layer ACT1 of the first thin film transistor TFT1 may be disposed on the barrier film BR. The first active layer ACT1 of the first thin film transistor TFT1 may include polycrystalline silicon, monocrystalline silicon, low-temperature polycrystalline silicon, or amorphous silicon.

The first active layer ACT1 may include a first channel region CHA1, a first source region S1, and a first drain region D1. The first channel region CHA1 may be a region overlapping a first gate electrode G1 in a third direction DR3 that is a thickness direction of the substrate SUB. The third direction DR3 may be defined as the thickness direction of the substrate SUB or the thickness direction of the display panel 100. The first source region S1 may be disposed on one side of the first channel region CHA1, and the first drain region D1 may be disposed on an opposite side of the first channel region CHA1. The first source region S1 and the first drain region D1 may be regions that do not overlap the first gate electrode G1 in the third direction DR3. The first source region S1 and the first drain region D1 may be regions having conductivity by doping a semiconductor material with ions.

A first gate insulating layer 131 may be disposed on a first channel region CHA1, a first source region S1, and a first drain region D1 of a first thin film transistor TFT1.

A first gate metal layer may be disposed on the first gate insulating layer 131. The first gate metal layer may include the first gate electrode G1 and the first capacitor electrode CAE1 of the first thin film transistor TFT1. The first gate electrode G1 may overlap the first active layer ACT1 in the third direction DR3.

A second gate insulating layer 132 may be disposed on the first gate electrode G1 and the first capacitor electrode CAE1 of the first thin film transistor TFT1.

A second gate metal layer may be disposed on the second gate insulating layer 132. The second gate metal layer may include a second capacitor electrode CAE2. The second capacitor electrode CAE2 may overlap the first capacitor electrode CAE1 of the first thin film transistor TFT1 in the third direction DR3. Since the second gate insulating layer 132 has a predetermined dielectric constant, the capacitor C1 (FIG. 4) may be formed by the first capacitor electrode CAE1, the second capacitor electrode CAE2, and the second gate insulating layer 132 disposed therebetween.

A first inter-insulating layer 141 may be disposed on the second capacitor electrode CAE2.

A second thin film transistor TFT2 may be disposed on the first inter-insulating layer 141. The second thin film transistor TFT2 may be any one of the second transistor T2 and the third transistor T3 shown in FIG. 4. The second thin film transistor TFT2 may include a second active layer ACT2 and a second gate electrode G2.

The second active layer ACT2 of the second thin film transistor TFT2 may be disposed on the first inter-insulating layer 141. The second active layer ACT2 may include an oxide semiconductor. In an embodiment, the second active layer ACT2 may be include indium (In)-gallium (Ga)-zinc (Zn)-oxygen (O) ("IGZO"), indium (In)- gallium (Ga)-zinc (Zn)-tin (Sn)-oxygen (O) ("IGZTO"), or indium (In)- gallium (Ga)-tin (Sn)-oxygen (O) ("IGTO"), for example.

The second active layer ACT2 may include a second channel region CHA2, a second source region S2, and a second drain region D2. The second channel region CHA2 may be a region overlapping the second gate electrode G2 in the third direction DR3. The second source region S2 may be disposed on one side of the second channel region CHA2, and the second drain region D2 may be disposed on an opposite side of the second channel region CHA2. The second source region S2 and the second drain region D2 may be regions that do not overlap the second gate electrode G2 in the third direction DR3. The second source region S2 and the second drain region D2 may be regions having conductivity by doping an oxide semiconductor with ions.

A third gate insulating layer 133 may be disposed on the second active layer ACT2 of the second thin film transistor TFT2.

A third gate metal layer may be disposed on the third gate insulating layer 133. The third gate metal layer may include the second gate electrode G2 of the second thin film transistor TFT2. The second gate electrode G2 may overlap the second active layer ACT2 in the third direction DR3.

A second inter-insulating layer 142 may be disposed on the second gate electrode G2 of the second thin film transistor TFT2.

The first data metal layer may be formed on the second inter-insulating layer 142. The first data metal layer may include a first connection electrode BE1, a second connection electrode BE2, and a third connection electrode BE3. The first connection electrode BE1 may be connected to the first drain region D of the first active layer ACT1 through a first connection hole BCT1 penetrating the first gate insulating layer 131, the second gate insulating layer 132, the first inter-insulating layer 141, the third gate insulating layer 133, and the second inter-insulating layer 142. The second connection electrode BE2 may be connected to the second source region S2 of the second active layer ACT2 through a second connection hole BCT2 penetrating the second inter-insulating layer 142. The third connection electrode BE3 may be connected to the second drain region D2 of the second active layer ACT2 through a third connection hole BCT3 penetrating the second inter-insulating layer 142.

On the first connection electrode BE1, the second connection electrode BE2, and the third connection electrode BE3, a first organic layer 160 for flattening the stepped portion caused by the first thin film transistor TFT1 and the second thin film transistor TFT2 may be disposed.

The second data metal layer may be disposed on the first organic layer 160. The second data metal layer may include a fourth connection electrode BE4. The fourth connection electrode BE4 may be connected to a first source connection electrode SBE1 through a fourth connection hole BCT4 penetrating the first organic layer 160.

A second organic layer 180 may be disposed on the fourth connection electrode BE4.

The barrier film BR, the first gate insulating layer 131, the second gate insulating layer 132, the third gate insulating layer 133, the first inter-insulating layer 141, and the second inter-insulating layer 142 may include or consist of an inorganic layer, e.g., silicon nitride (SiNₓ), silicon oxynitride (SiON), silicon oxide (SiOₓ), titanium oxide (TiOₓ), or aluminum oxide (AlO_{y}).

The first gate metal layer, the second gate metal layer, the third gate metal layer, the first data metal layer, and the second data metal layer may include or consist of a single layer or multiple layers including or consisting of any one of molybdenum (Mo), aluminum (Al), chromium (Cr), gold (Au), titanium (Ti), nickel (Ni), neodymium (Nd), and copper (Cu) or any alloys thereof.

The first organic layer 160 and the second organic layer 180 may include or consist of an organic layer such as acrylic resin, epoxy resin, phenolic resin, polyamide resin, or polyimide resin.

A plurality of light-emitting elements LE and a bank 190 may be disposed on the second organic layer 180. Each of the plurality of light-emitting elements LE may include a pixel electrode PXE, the light-emitting layer EL, and a common electrode CE. Each of the plurality of light-emitting elements LE refers to an element that emits light by recombining holes from the pixel electrode PXE and electrons from the common electrode CE in the light-emitting layer EL. Each of the plurality of light-emitting elements LE may be an organic light-emitting diode in which the light-emitting layer EL includes or consists of an organic light-emitting layer, but the invention is not limited thereto.

A pixel electrode layer may be disposed on the second organic layer 180. The pixel electrode layer may include the pixel electrodes PXE. Each of the pixel electrodes PXE may be connected to the fourth connection electrode BE4 through a pixel connection hole PCT penetrating the second organic layer 180. Each of the pixel electrodes PXE may be connected to the first source region S1 or the first drain region D1 of the first thin film transistor TFT1 through the first connection electrode BE1 and the fourth connection electrode BE4. Accordingly, the voltage controlled by the first thin film transistor TFT1 may be applied to each of the pixel electrodes PXE. The pixel electrode layer may be formed as a single layer or multiple layers including or consisting of any one of molybdenum (Mo), aluminum (Al), chromium (Cr), gold (Au), titanium (Ti), nickel (Ni), neodymium (Nd) and copper (Cu) or any alloys thereof.

The bank 190 serves to define the first to third emission areas ELU1, ELU2, and ELU3 of the display pixels. To this end, the bank 190 may be formed to expose a partial region of the pixel electrode PXE on the second organic layer 180. The bank 190 may cover the edge of the pixel electrode PXE.

A spacer 191 to stably support the mask during the process of depositing the light-emitting layer EL may be disposed on the bank 190.

The bank 190 and the spacer 191 may include or consist of an organic layer such as acrylic resin, epoxy resin, phenolic resin, polyamide resin, or polyimide resin.

Each of the light-emitting layers EL may be exposed without being covered by the bank 190 and may be disposed on the pixel electrode PXE corresponding thereto. Each of the light-emitting layers EL may include an organic material and may emit predetermined light. In an embodiment, the light-emitting layer EL of the first emission area ELU1 may emit the first light, the light-emitting layer EL of the second emission area ELU2 may emit the second light, and the light-emitting layer EL of the third emission area ELU3 may emit the third light, for example. Each of the light-emitting layers EL may include a hole transporting layer, an organic material layer, and an electron transporting layer.

The common electrode CE may be disposed on the light-emitting layers EL and the bank 190. The common electrode CE may be formed to cover the top surface of each of the light-emitting layers EL and the top surface of the bank 190. The common electrode CE may be commonly disposed across the entirety of the display area DA. The common electrode CE may also be disposed in a partial area of the non-display area NDA.

The common electrode CE may include or consist of a transparent conductive material ("TCO") such as indium tin oxide ("ITO") or indium zinc oxide ("IZO") that may transmit light in the top emission structure, or a semi-transmissive conductive material such as magnesium (Mg), silver (Ag), or an alloy of magnesium (Mg) and silver (Ag). When the common electrode CE includes or consists of a semi-transmissive conductive material, the light emission efficiency of each of the light-emitting elements LE may be increased due to a micro-cavity effect.

An encapsulation layer TFE may be formed on the common electrode CE. The encapsulation layer TFE may include at least one inorganic layer to prevent oxygen or moisture from permeating into the light-emitting layer EL. Additionally, the encapsulation layer TFE may include at least one organic layer to prevent voids from occurring in at least one inorganic layer due to foreign matters such as dust.

The encapsulation layer TFE may include a first inorganic encapsulation layer TFE1, the organic encapsulation layer TFE2, an intermediate inorganic encapsulation layer 155, and a second inorganic encapsulation layer TFE3 that are sequentially stacked. The first inorganic encapsulation layer TFE1 may be disposed on the common electrode CE, the organic encapsulation layer TFE2 may be disposed on the first inorganic encapsulation layer TFE1, the intermediate inorganic encapsulation layer 155 may be disposed on an organic encapsulation layer, and the second inorganic encapsulation layer TFE3 may be disposed on the organic encapsulation layer TFE2.

The first inorganic encapsulation layer TFE1, the intermediate inorganic encapsulation layer 155, and the second inorganic encapsulation layer TFE3 may include or consist of multiple films in which one or more inorganic layers of silicon nitride (SiNₓ), silicon oxynitride (SiON), silicon oxide (SiOₓ), titanium oxide (TiOₓ), or aluminum oxide (AlOₓ) are alternately stacked. The organic encapsulation layer TFE2 may include or consist of an organic layer such as acrylic resin, epoxy resin, phenolic resin, polyamide resin, or polyimide resin.

A polarizing layer POL may be disposed on the encapsulation layer TFE to prevent visibility deterioration due to external light. The polarizing layer POL may include a first base member, a linear polarization plate, a phase retardation film such as a quarter-wave plate (λ/4 plate), and a second base member. The polarizing layer POL may be replaced with another anti-reflection layer, such as a color filter layer including a plurality of color filters.

A sensor electrode layer including sensor electrodes to detect touch may be disposed between the encapsulation layer TFE and the polarizing layer POL.

A cover window CSUB may be disposed on the polarizing layer POL. The cover window CSUB may be attached to the polarizing layer POL by an adhesive member ADL such as an optically clear resin ("OCR").

The adhesive member ADL may be disposed between the polarizing layer POL and the cover window CSSUB. The adhesive member ADL may be a transparent adhesive layer.

FIG. 7 is a cross-sectional view of the display panel taken along line I-I' of FIG. 2. FIG. 7 illustrates a cross section of the display panel 100 illustrating the non-display area NDA on the first side of the display panel 100.

Referring to FIG. 7, transistors of the scan driving circuits GDC1 and GDC2 and the emission driving circuits EDC1 and EDC2 may be disposed on the barrier film BR. Each transistor may include an active layer and a gate electrode. An active layer ACTE may include a channel region CHE, a source region SE, and a drain region DE. The active layer ACTE may be disposed on the barrier film BR. The gate electrode GE may overlap the channel region CHE in the third direction DR3 and may be disposed on the first gate insulating layer 131.

The active layer ACTE may include polycrystalline silicon, monocrystalline silicon, low-temperature polycrystalline silicon, or amorphous silicon.

A groove Gval penetrating the first organic layer 160 and the second organic layer 180 may be defined in an inorganic area VAL. The first organic layer 160 and the second organic layer 180 next (adjacent) to an edge on the first side of the display panel 100 in the inorganic area VAL may be spaced apart from the first organic layer 160 and the second organic layer 180 next (adjacent) to the display area DA. The first organic layer 160 and the second organic layer 180 may be cut off in the inorganic area VAL. Accordingly, although oxygen or moisture permeates through the first organic layer 160 and the second organic layer 180 at the edge on the first side of the display panel 100, the oxygen or moisture may be prevented from being transmitted to the first organic layer 160 and the second organic layer 180 next (adjacent) to the display area DA and affecting the light-emitting layer EL. In plan view, the groove Gval may have a closed curve shape surrounding the display area DA.

The first data metal layer may further include a first power connection electrode VSCE1 and a second power connection electrode VSCE2. The first power connection electrode VSCE1 and the second power connection electrode VSCE2 may be disposed on the second inter-insulating layer 142.

The first power connection electrode VSCE1 may be disposed in the groove Gval penetrating the first organic layer 160 and the second organic layer 180. The groove Gval may have a V-shaped cross section.

The second power connection electrode VSCE2 may be disposed on the second inter-insulating layer 142 that is exposed and not covered by the first organic layer 160 in the dam area DAMA.

The first power line VSL may include a first sub-power line SVSL1 and a second sub-power line SVSL2.

The first sub-power line SVSL1 may be disposed on the first organic layer 160. The first sub-power line SVSL1 may be connected to the first power connection electrode VSCE1 exposed in the groove Gval of the inorganic area VAL. The first sub-power line SVSL1 may be disposed on the second power connection electrode VSCE2 in the dam area DAMA.

The second sub-power line SVSL2 may be disposed on the second organic layer 180. The second sub-power line SVSL2 may be disposed on the first sub-power line SVSL1 in the groove Gval of the inorganic area VAL. The second sub-power line SVSL2 may be disposed on the first sub-power line SVSL1 in the dam area DAMA.

In an embodiment, the second power connection electrode VSCE2, the first sub-power line SVSL1, and the second sub-power line SVSL2 may be sequentially stacked in the dam area DAMA, for example.

The common electrode CE may be disposed on the second organic layer 180 and the bank 190 that are exposed and not covered by the bank 190. The common electrode CE may be connected to the second sub-power line SVSL2 in the groove Gval of the inorganic area VAL. The common electrode CE may be disposed on the sidewall of the groove Gval of the inorganic area VAL. Accordingly, when external light is incident on the groove Gval of the inorganic area VAL, the external light may be unpredictably and diffusely reflected by the common electrode CE disposed on the sidewall of the groove Gval of the inorganic area VAL.

The first dam DAM1 and the second dam DAM2 may be disposed on the first power line VSL.

The first dam DAM1 and the second dam DAM2 may be structures to prevent the organic encapsulation layer TFE2 from overflowing to the edge on the first side of the display panel 100. The first dam DAM1 and the second dam DAM2 may be structures for confining the organic encapsulation layer TFE2.

The first dam DAM1 may include a first sub-dam SDAM1_1, a second sub-dam SDAM2_1, and a third sub-dam SDAM3_1 sequentially stacked on the first power line VSL. The first sub-dam SDAM1_1 may include or consist of the same material as that of the second organic layer 180, the second sub-dam SDAM2_1 may include or consist of the same material as that of the bank 190, and the third sub-dam SDAM3_1 may include or consist of the same material as that of the spacer 191.

The second sub-power line SVSL2 may be disposed on the first sub-dam SDAM1_1 of the first dam DAM1. The second sub-power line SVSL2 may be disposed to cover the first sub-dam SDAM1_1 of the first dam DAM1. In an embodiment, the second sub-power line SVSL2 may be disposed on the top surface and the side surface of the first sub-dam SDAM1_1 of the first dam DAM1, for example. The second sub-dam SDAM2_1 of the first dam DAM1 may be disposed on the second sub-power line SVSL2.

The second dam DAM2 may include a first sub-dam SDAM1_2, a second sub-dam SDAM2_2, a third sub-dam SDAM3_2, and a fourth sub-dam SDAM4_2 sequentially stacked on the second inter-insulating layer 142. The first sub-dam SDAM1_2 may include or consist of the same material as that of the first organic layer 160, and the second sub-dam SDAM2_2 may include or consist of the same material as that of the second organic layer 180. The third sub-dam SDAM3_2 may include or consist of the same material as that of the bank 190, and the fourth sub-dam SDAM4_2 may include or consist of the same material as that of the spacer 191.

The first sub-dam SDAM1_2 of the second dam DAM2 may be disposed on the second power connection electrode VSCE2. In addition, the first sub-power line SVSL1 may be disposed on the first sub-dam SDAM1_2 of the second dam DAM2, and the second sub-dam SDAM2_2 of the second dam DAM2 may be disposed on the first sub-power line SVSL1. In addition, the second sub-power line SVSL2 may be disposed on the second sub-dam SDAM2_2 of the second dam DAM2, and the third sub-dam SDAM3_2 of the second dam DAM2 may be disposed on the second sub-power line SVSL2.

The first inorganic encapsulation layer TFE1and the second inorganic encapsulation layer TFE3 may contact each other outside the second dam DAM2, so that an inorganic encapsulation area IEA including only an inorganic layer may be disposed. An organic layer is not disposed in the inorganic encapsulation area IEA. The display area DA may be surrounded by the inorganic encapsulation area IEA, so that external oxygen or moisture may be prevented from permeating into the light-emitting layer EL of the display area DA. The inorganic encapsulation area IEA may be disposed next (adjacent) to the edge on the first side of the display panel 100. The inorganic encapsulation area IEA may be disposed closer to the dam area DAMA than the inorganic area VAL.

The light blocking layer BM may be disposed on one surface of the cover window CSUB. The light blocking layer BM may overlap the groove Gval of the inorganic area VAL in the third direction DR3.

In an embodiment, the adhesive member ADL may include a first adhesive layer 710 (hereinafter, an intermediate adhesive layer 710), a second adhesive layer 711 (hereinafter, a first peripheral adhesive layer 711), and a third adhesive layer 712 (hereinafter, a second peripheral adhesive layer 712). The configuration of the adhesive member ADL will be described in detail as follows.

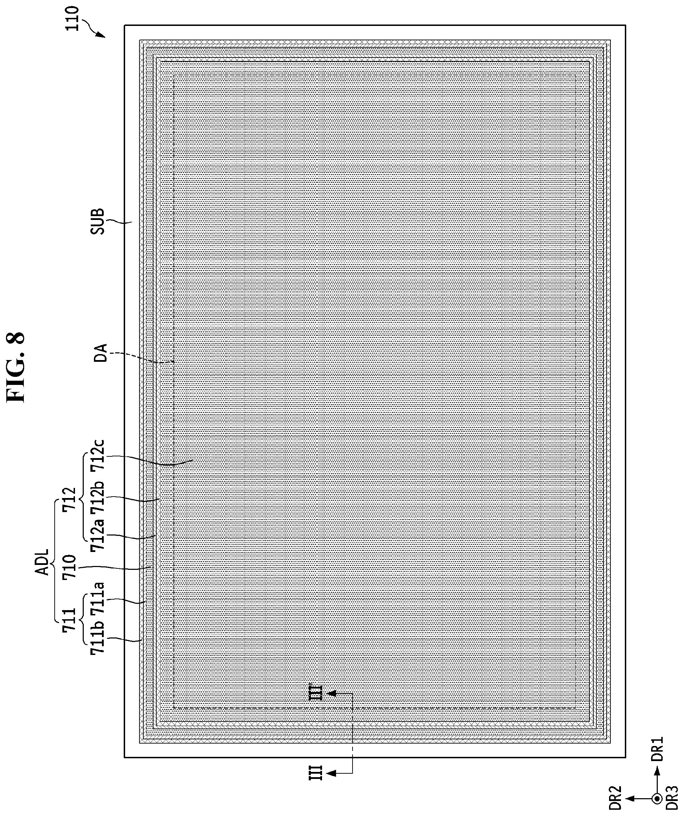

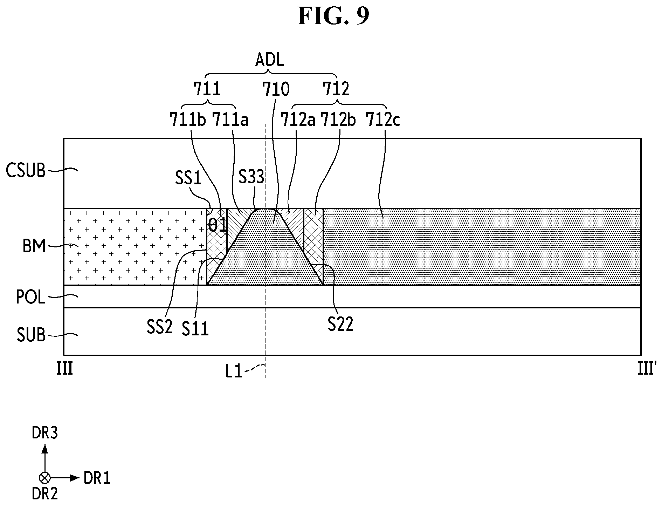

FIG. 8 is a schematic plan view of the display panel 110 including an adhesive layer in an embodiment, and FIG. 9 is a cross-sectional view taken along line III-III' of FIG. 8.

As illustrated in FIGS. 8 and 9, the adhesive member ADL may be disposed on the substrate SUB. In an embodiment, as illustrated in FIG. 9, the adhesive member ADL may be disposed on the polarizing layer POL to overlap the substrate SUB, for example. In the area of the substrate SUB around the adhesive member ADL, the light blocking layer BM may be disposed as shown in fig. 7.

The adhesive member ADL may include or consist of a material including resin. The resin may be a liquid resin with viscosity. The resin may be a resin having a light transmissive property, and in some embodiments, the resin may be a photocurable resin or a thermosetting resin.

In an embodiment, components between the substrate SUB and the polarizing layer POL in FIGS. 6 and 7 may be further disposed between the substrate SUB and the polarizing layer POL in FIG. 9, for example.

An angle θ1 defined between a side surface SS2 and a top surface SS1 of the adhesive member ADL may be a right angle. In an embodiment, when the surface of the adhesive member ADL facing the light blocking layer BM is defined as the side surface SS2 of the adhesive member ADL, and the surface of the adhesive member ADL facing the cover window CSUB is defined as the top surface SS1 of the adhesive member ADL, the interior angle θ1 defined between the side surface SS2 of the adhesive member ADL and the top surface SS1 of the adhesive member ADL may be 90 degrees to 135 degrees, for example. In an embodiment, the interior angle θ1 described above may be 90 degrees. The top surface SS1 and the side surface SS2 of the adhesive member ADL may be both edges of the adhesive member ADL. The top surface SS1 may be in contact with the cover window CSUB. The side surface SS2 may be in contact with the light blocking layer BM.

The adhesive member ADL may include the intermediate adhesive layer 710, the first peripheral adhesive layer 711, and the second peripheral adhesive layer 712.

In plan view as illustrated in FIG. 8, the intermediate adhesive layer 710 may have a closed curve shape surrounding the display area DA. The intermediate adhesive layer 710 may be disposed between the first peripheral adhesive layer 711 and the second peripheral adhesive layer 712.

In cross-sectional view as illustrated in FIG. 9, the intermediate adhesive layer 710 may have a width that gradually decreases along the direction (e.g., the third direction DR3) toward the cover window CSUB. In an embodiment, the intermediate adhesive layer 710 may have a triangular cross section, for example. In an embodiment, a top surface S33 of the intermediate adhesive layer 710 may have a round shape (or parabolic shape). In an embodiment, the top surface S33 of the intermediate adhesive layer 710 may be a surface facing (or in contact with) the cover window CSUB, so that the top surface S33 of the intermediate adhesive layer 710 may have a round shape (or parabolic shape) convex toward the cover window CSUB, for example.

In an embodiment, each of a first side surface S11 (e.g., the outer surface of the intermediate adhesive layer 710) and a second side surface S22 (e.g., the inner surface of the intermediate adhesive layer 710) facing each other of the intermediate adhesive layer 710 may form an inclined diagonal shape. The center of the intermediate adhesive layer 710 may pass through the center (e.g., the center of the top surface S33 of the intermediate adhesive layer 710) between the first side surface S11 of the intermediate adhesive layer 710 and the second side surface S22 of the intermediate adhesive layer 710, and may overlap an imaginary extension line L1 parallel to the side surface SS2 of the adhesive member ADL (or parallel to the third direction DR3). The first side surface S11 and the second side surface S22 of the intermediate adhesive layer 710 may have a symmetrical shape with respect to the extension line L1 described above.

The first side surface S11 and the second side surface S22 may be angled to each other. The first side surface S11 and the second side surface S22 may form a pyramid shape. Thus, the intermediate adhesive layer 710 may have a triangular cross section.

The first peripheral adhesive layer 711 may be disposed on one side of the intermediate adhesive layer 710. In an embodiment, as illustrated in FIG. 9, the first peripheral adhesive layer 711 may be disposed between the light blocking layer BM and the first side surface S11 of the intermediate adhesive layer 710, for example.

The first peripheral adhesive layer 711 may include a plurality of first sub-adhesive layers 711a and 711b having different densities. In an embodiment, the plurality of first sub-adhesive layers 711a and 711b may have higher densities as they are disposed farther from the intermediate adhesive layer 710, for example. As a predetermined example, the plurality of first sub-adhesive layers 711a and 711b may have higher densities as they are disposed farther from the center (or the extension line L1) of the intermediate adhesive layer 710.

In an embodiment, the first peripheral adhesive layer 711 may include a first-first sub-adhesive layer 711a and a first-second sub-adhesive layer 711b having different densities. The first-first sub-adhesive layer 711a may be disposed between the intermediate adhesive layer 710 and the first-second sub-adhesive layer 711b. The first-second sub-adhesive layer 711b may be disposed between the first-first sub-adhesive layer 711a and the light blocking layer BM. The first-first sub-adhesive layer 711a among the plurality of first sub-adhesive layers 711a and 711b may be disposed closer to the center (or the extension line L1) of the intermediate adhesive layer 710, and the first-second sub-adhesive layer 711b among the plurality of first sub-adhesive layers 711a and 711b may be disposed farther from the center (or the extension line L1) of the intermediate adhesive layer 710. In other words, the first-second sub-adhesive layer 711b may be disposed farther from the center (or the extension line L1) of the intermediate adhesive layer 710 than the first-first sub-adhesive layer 711a.

The first-first sub-adhesive layer 711a and the first-second sub-adhesive layer 711b may be in parallel to each other. The first-first sub-adhesive layer 711a and the first-second sub-adhesive layer 711b may each contact a half of the length of the first side surface S11.

In an embodiment, the density of the first-second sub-adhesive layer 711b may be higher than the density of the first-first sub-adhesive layer 711a. In other words, the first-first sub-adhesive layer 711a disposed closer to the intermediate adhesive layer 710 may have a relatively lower density, and the first-second sub-adhesive layer 711b disposed farther from the intermediate adhesive layer 710 may have a relatively higher density.

In an embodiment, the angle θ1 defined between the side surface (e.g., the side surface SS2 of the adhesive member ADL) of the first-second sub-adhesive layer 711b and the top surface (e.g., the top surface SS1 of the adhesive member ADL) of the first-second sub-adhesive layer 711b may be 90 degrees to 135 degrees. In an embodiment, the interior angle θ1 described above may be 90 degrees.

The second peripheral adhesive layer 712 may be disposed on an opposite side of the intermediate adhesive layer 710. In an embodiment, as illustrated in FIG. 9, the second peripheral adhesive layer 712 may be disposed on the second side surface S22 of the intermediate adhesive layer 710, for example.

The second peripheral adhesive layer 712 may include a plurality of second sub-adhesive layers 712a, 712b, and 712c having different densities. In an embodiment, the plurality of second sub-adhesive layers 712a, 712b, and 712c may have higher densities as they are disposed farther from the intermediate adhesive layer 710, for example. As a predetermined example, the plurality of second sub-adhesive layers 712a, 712b, and 712c may have higher densities as they are disposed farther from the center (or the extension line L1) of the intermediate adhesive layer 710.

In an embodiment, the second peripheral adhesive layer 712 may include a second-first sub-adhesive layer 712a, a second-second sub-adhesive layer 712b, and a second-third sub-adhesive layer 712c having different densities. The second-first sub-adhesive layer 712a may be disposed between the intermediate adhesive layer 710 and the second-second sub-adhesive layer 712b. The second-second sub-adhesive layer 712b may be disposed between the second-first sub-adhesive layer 712a and the second-third sub-adhesive layer 712c. The second-third sub-adhesive layer 712c may be disposed close to the second-second sub-adhesive layer 712b. The second-first sub-adhesive layer 712a among the plurality of second sub-adhesive layers 712a, 712b, and 712c may be disposed closest to the center (or the extension line L1) of the intermediate adhesive layer 710, and the second-third sub-adhesive layer 712c among the plurality of second sub-adhesive layers 712a, 712b, and 712c may be disposed farthest from the center (or the extension line L1) of the intermediate adhesive layer 710. The second-second sub-adhesive layer 712b may be disposed farther from the center (or the extension line L1) of the intermediate adhesive layer 710 than the second-first sub-adhesive layer 712a, and may be disposed closer to the center (or the extension line L1) of the intermediate adhesive layer 710 than the second-third sub-adhesive layer 712c. In other words, the second-second sub-adhesive layer 712b may be disposed farther from the center (or the extension line L1) of the intermediate adhesive layer 710 than the second-first sub-adhesive layer 712a, and the second-third sub-adhesive layer 712c may be disposed farther from the center (or the extension line L1) of the intermediate adhesive layer 710 than the second-second sub-adhesive layer 712b.

The second-first sub-adhesive layer 712a and the second-second sub-adhesive layer 712b may be in parallel to each other. The second-first sub-adhesive layer 712a and the second-second sub-adhesive layer 712b may each contact a half of the length of the second side surface S22.

In an embodiment, the density of the second-second sub-adhesive layer 712b may be higher than the density of the second-first sub-adhesive layer 712a, and the density of the second-third sub-adhesive layer 712c may be higher than the density of the second-second sub-adhesive layer 712b. In other words, the second-first sub-adhesive layer 712a disposed closest to the intermediate adhesive layer 710 may have a relatively lower density, and the second-third sub-adhesive layer 712c disposed farthest from the intermediate adhesive layer 710 may have a relatively higher density. The density of the second-second sub-adhesive layer 712b between the second-first sub-adhesive layer 712a and the second-third sub-adhesive layer 712c may be higher than the density of the second-first sub-adhesive layer 712a, and may be lower than the density of the second-third sub-adhesive layer 712c.

In an embodiment, the density of the intermediate adhesive layer 710 may be different from the density of at least one sub-adhesive layer included in the first peripheral adhesive layer 711. In an embodiment, the density of the intermediate adhesive layer 710 may be higher than the density of the first-first sub-adhesive layer 711a, for example. Additionally, the density of the intermediate adhesive layer 710 may be higher than the density of the first-second sub-adhesive layer 711b.

The intermediate adhesive layer 710 may form kind of a frame of the display device or display panel. The intermediate adhesive layer 710 may have a rectangular shape. The intermediate adhesive layer 710 may be spaced apart from a side surface of the display device or display panel.

In an embodiment, the density of the intermediate adhesive layer 710 may be different from the density of at least one sub-adhesive layer included in the second peripheral adhesive layer 712. In an embodiment, the density of the intermediate adhesive layer 710 may be higher than the density of the second-first sub-adhesive layer 712a, for example. Additionally, the density of the intermediate adhesive layer 710 may be higher than the density of the second-second sub-adhesive layer 712b.

In an embodiment, the density of the intermediate adhesive layer 710 may be the same as the density of at least one sub-adhesive layer included in the second peripheral adhesive layer 712. In an embodiment, the density of the intermediate adhesive layer 710 may be the same as the density of the second-third sub-adhesive layer 712c, for example.

In an embodiment, the density of the intermediate adhesive layer 710 and the density of the second-third sub-adhesive layer 712c may be higher than the densities of remaining (the other) sub-adhesive layers.

In an embodiment, in a plan view as illustrated in FIG. 8, the second-second sub-adhesive layer 712b may surround the display area DA and the second-third sub-adhesive layer 712c. In addition, in a plan view as illustrated in FIG. 8, the second-first sub-adhesive layer 712a may surround the display area DA, the second-third sub-adhesive layer 712c, and the second-second sub-adhesive layer 712b. In addition, in a plan view as illustrated in FIG. 8, the intermediate adhesive layer 710 may surround the display area DA, the second-third sub-adhesive layer 712c, the second-second sub-adhesive layer 712b, and the second-first sub-adhesive layer 712a. In addition, in a plan view as illustrated in FIG. 8, the first-first sub-adhesive layer 711a may surround the display area DA, the second-third sub-adhesive layer 712c, the second-second sub-adhesive layer 712b, the second-first sub-adhesive layer 712a, and the intermediate adhesive layer 710. In addition, in a plan view as illustrated in FIG. 8, the first-second sub-adhesive layer 711b may surround the display area DA, the second-third sub-adhesive layer 712c, the second-second sub-adhesive layer 712b, the second-first sub-adhesive layer 712a, the intermediate adhesive layer 710, and the first-first sub-adhesive layer 711a.

In an embodiment, the first peripheral adhesive layer 711 and the second peripheral adhesive layer 712 may not be connected to each other. In other words, the first peripheral adhesive layer 711 and the second peripheral adhesive layer 712 may be separated from each other by the intermediate adhesive layer 710 therebetween. Accordingly, the first-first sub-adhesive layer 711a and the second-first sub-adhesive layer 712a may not be connected to each other but may be separated, for example.

In an embodiment, the first peripheral adhesive layer 711 and the second peripheral adhesive layer 712 may not be disposed between the top surface of the intermediate adhesive layer 710 and the cover window CSUB. In an embodiment, the top surface (e.g., the center of the top surface S33) of the intermediate adhesive layer 710 and the cover window CSUB may be in contact (e.g., direct contact) with each other, for example.

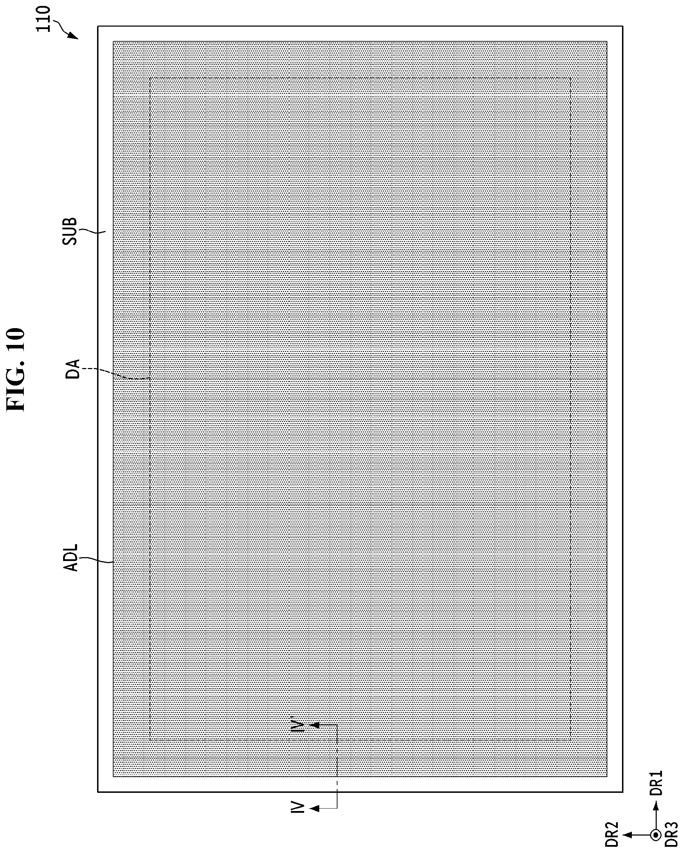

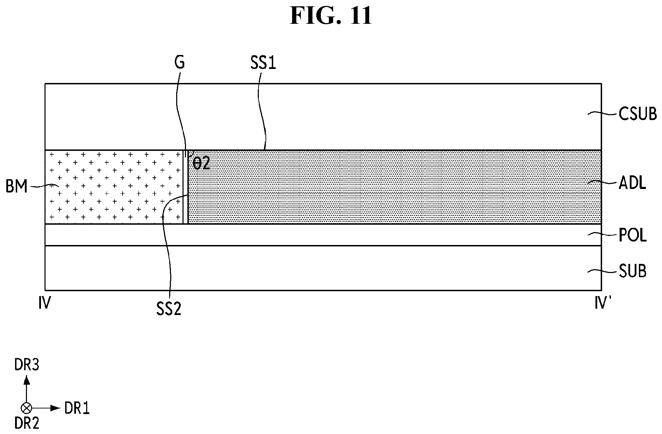

FIG. 10 is a schematic plan view of the display panel 110 including an adhesive layer in an embodiment, and FIG. 11 is a cross-sectional view taken along line IV-IV' of FIG. 10.

As illustrated in FIGS. 10 and 11, the adhesive member ADL may be disposed on the substrate SUB. In an embodiment, as illustrated in FIG. 11, the adhesive member ADL may be disposed on the polarizing layer POL to overlap the substrate SUB, for example.

In an embodiment, components between the substrate SUB and the polarizing layer POL in FIGS. 6 and 7 may be further disposed between the substrate SUB and the polarizing layer POL in FIG. 11, for example.

In plan view as illustrated in FIG. 10, an edge (e.g., a side surface of the adhesive member ADL) of the adhesive member ADL may surround the display area DA.

An angle θ2 defined between the side surface SS2 and the top surface SS1 of the adhesive member ADL may be a right angle. In an embodiment, when the surface of the adhesive member ADL facing the light blocking layer BM is defined as the side surface SS2 of the adhesive member ADL, and the surface of the adhesive member ADL facing the cover window CSUB is defined as the top surface SS1 of the adhesive member ADL, the interior angle θ2 defined between the side surface SS2 of the adhesive member ADL and the top surface SS1 of the adhesive member ADL may be 90 degrees to 135 degrees, for example. In an embodiment, the interior angle θ2 described above may be 90 degrees.

In an embodiment, the light blocking layer BM and the adhesive member ADL may be spaced apart from each other. In an embodiment, a gap G may be defined between the light blocking layer BM and the adhesive member ADL (or the side surface SS2 of the adhesive member), for example. In plan view, the gap G may surround the adhesive member ADL. The light blocking layer BM and the adhesive member ADL may not contact each other due to the gap G. The angle θ2 defined between the side surface SS2 and the top surface SS1 of the adhesive member ADL may form a right angle by a display device manufacturing method to be described later, and thus, the side surface SS2 and the top surface SS1 of the adhesive member ADL at the edge of the adhesive member ADL may maintain a right angle state although the side surface SS2 of the adhesive member ADL is not supported by the light blocking layer BM due to the gap G described above.

In another embodiment, the light blocking layer BM and the adhesive member ADL in FIG. 10 may contact each other as illustrated in FIG. 7 described above.

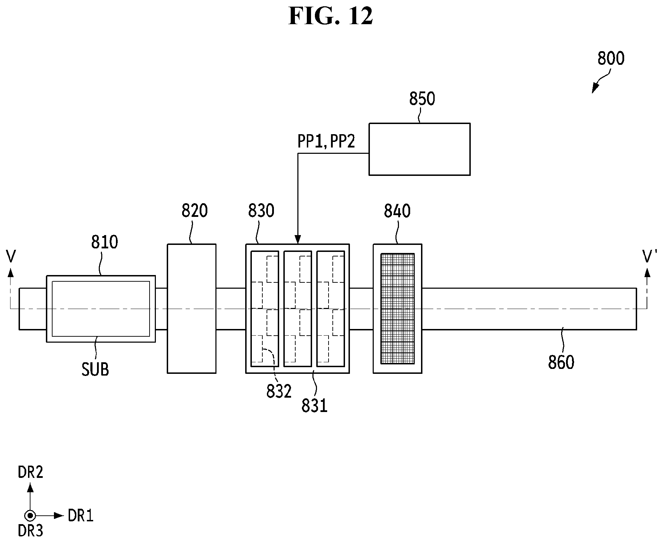

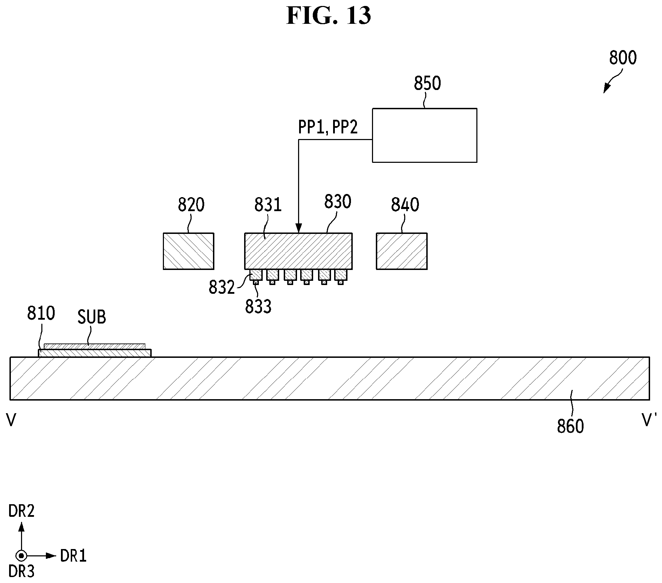

FIG. 12 is a schematic diagram of an adhesive member forming apparatus 800 for the display device in an embodiment, and FIG. 13 is a cross-sectional view taken along line V-V' of FIG. 12.

As illustrated in FIGS. 12 and 13, the adhesive member forming apparatus 800 may include a guide rail 860, a stage 810, an alignment device 820, an inkjet printing device 830, a curing device 840, and a printing pattern providing device 850.

The stage 810, the alignment device 820, the inkjet printing device 830, and the curing device 840 may be disposed above the guide rail 860.

The guide rail 860 may extend along the first direction DR1.

The stage 810 may support the substrate SUB. The substrate SUB may be placed on the stage 810. The stage 810 may move along the guide rail 860. In an embodiment, the stage 810 may move along the first direction DR1 on the guide rail 860, for example. Additionally, the stage 810 may move in a reverse direction (hereinafter referred to as first reverse direction) of the first direction DR1 on the guide rail 860.

The alignment device 820 may be disposed above the guide rail 860 to overlap the guide rail 860. The alignment device 820 may include a vision alignment device (or vision alignment system). The alignment device 820 may automatically recognize a reference mark (e.g., alignment mark) of the substrate SUB, may calculate the correct position error and rotation error, or the like of the substrate SUB based on the recognition result, and may align the substrate SUB to the correct position when it is confirmed that the alignment state of the substrate SUB is poor based on the calculation result.

The inkjet printing device 830 may be disposed on the guide rail 860 to overlap the guide rail 860. In an embodiment, the inkjet printing device 830 may be disposed between the alignment device 820 and the curing device 840 above the guide rail 860, for example. The inkjet printing device 830 may provide a raw material (e.g., resin) of the adhesive member ADL through an inkjet printing method. The inkjet printing method may manufacture patterns by forming drops of several tens of micrometers (µm) in desired positions through a non-contact patterning technique, and has advantages in which the adhesive is less consumed unlike other printing techniques and the number of processes may be dramatically reduced. The inkjet printing device 830 may eject a raw material (e.g., resin) of the adhesive member ADL onto the substrate SUB through an inkjet printing method. The inkjet printing device 830 may include a support portion 831 and a plurality of heads 832 connected to the support portion. Each of the heads 832 may include a plurality of nozzles 833. The inkjet printing device 830 may eject resin through the nozzles 833. In an embodiment, the inkjet printing device 830 may individually control the opening degree (e.g., opening amount) of each of the nozzles 833. As the ejection hole of the nozzle 833 opens more, the amount of resin ejected from the nozzle 833 (e.g., the ejection amount of resin per unit time) may increase.

The printing pattern providing device 850 may provide the inkjet printing device 830 with a pattern (or printing pattern) of a raw material (e.g., resin) to be applied (or formed) on the substrate SUB. In an embodiment, the printing pattern providing device 850 may provide a plurality of different printing patterns. In an embodiment, the printing pattern providing device 850 may provide a first printing pattern PP1 and a second printing pattern PP2 different from each other, for example.

The first printing pattern PP1 may include a pattern corresponding to the shape of the intermediate adhesive layer 710 described above, for example. In other words, the first printing pattern PP1 may include a pattern image for a raw material in a closed curve shape surrounding the display area DA.

The second printing pattern PP2 may include a pattern corresponding to the shape of the first peripheral adhesive layer 711 and the second peripheral adhesive layer 712 described above, for example. In other words, the second printing pattern PP2 may include a pattern image for the raw materials respectively disposed on the first side surface S11 (or outer surface) and the second side surface S22 (or inner surface) of the first printing pattern PP1 described above.

The first printing pattern PP1 and the second printing pattern PP2 described above may be transmitted to the inkjet printing device 830. In an embodiment, the printing pattern providing device 850 may select any one of the first printing pattern PP1 and the second printing pattern PP2 described above according to a control signal (e.g., a control signal from a control device) from the outside, and may provide the selected printing pattern to the inkjet printing device 830, for example.

When the inkjet printing device 830 ejects the raw material according to the first printing pattern PP1, the raw material may be ejected on the substrate SUB to form the shape of the intermediate adhesive layer 710.

When the inkjet printing device 830 ejects the raw material according to the second printing pattern PP2, the raw material may be ejected onto the substrate SUB to form the shape of the peripheral adhesive layer (e.g., the first peripheral adhesive layer 711 and the second peripheral adhesive layer 712).

The curing device 840 may be disposed above the guide rail 860 to overlap the guide rail 860. The curing device 840 may cure a raw material (e.g., resin) on the substrate. To this end, in an embodiment, the curing device 840 may provide at least one of ultraviolet, near-ultraviolet, or heat.

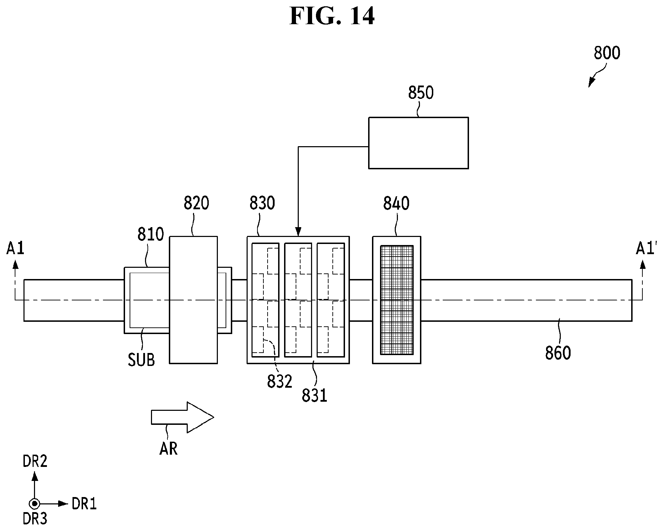

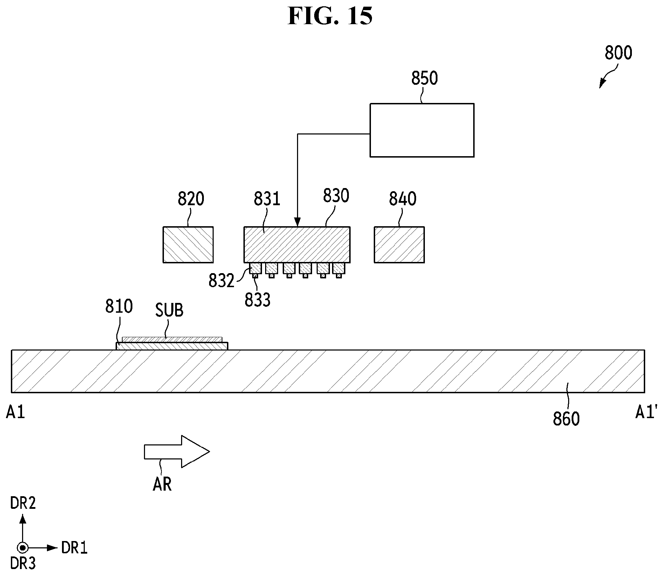

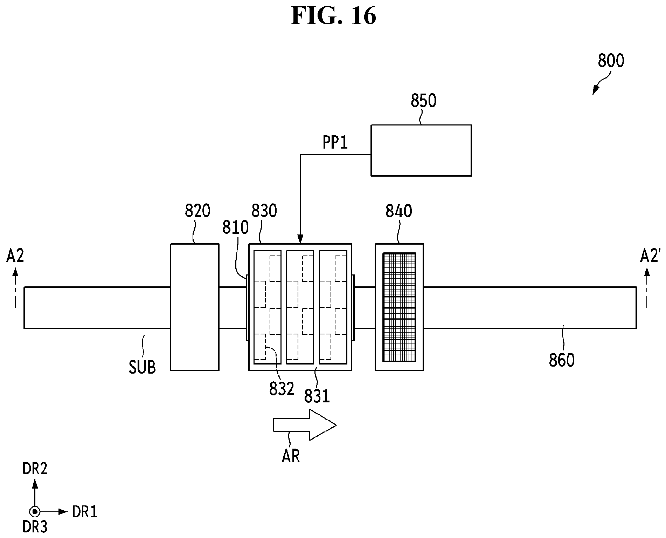

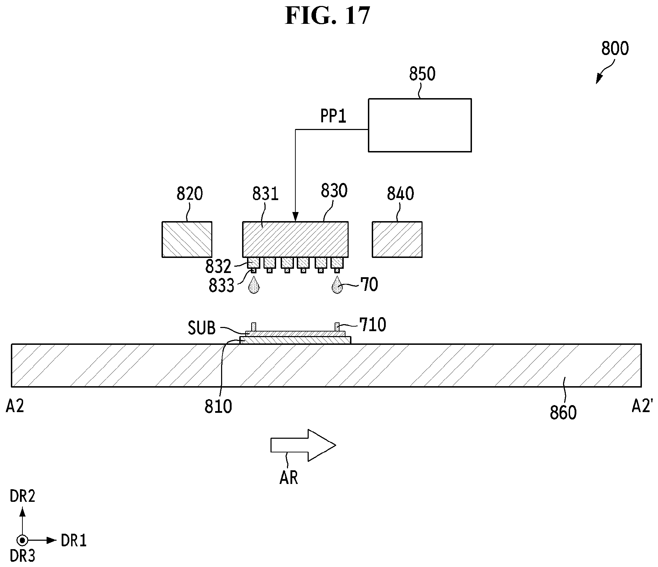

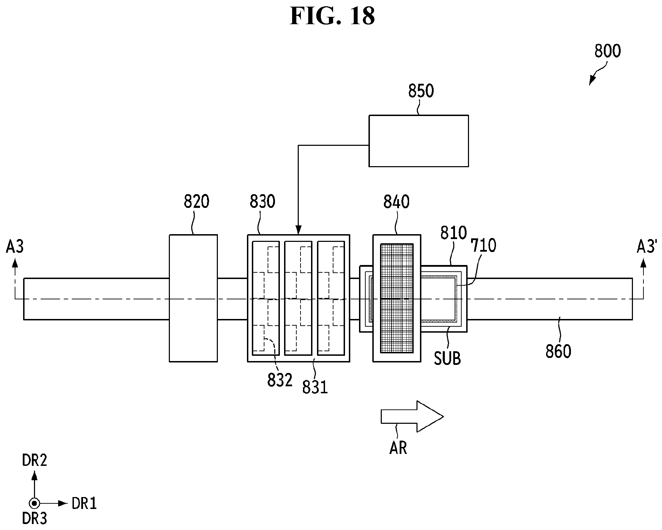

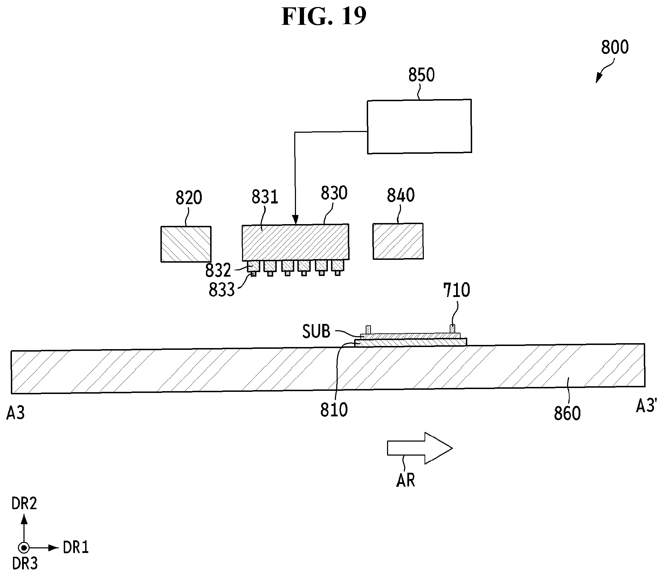

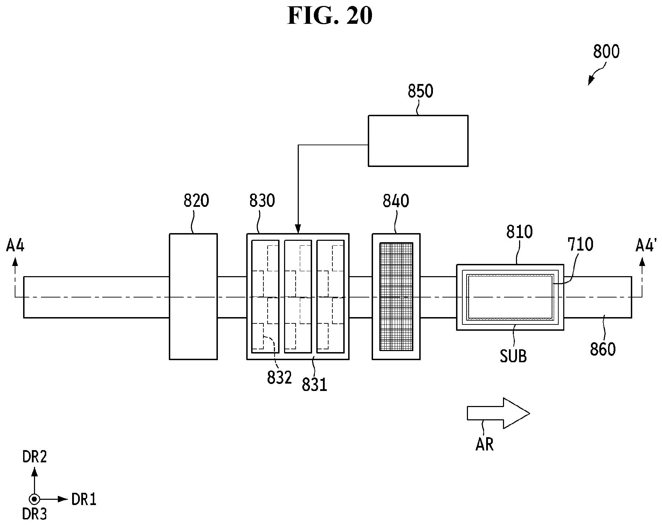

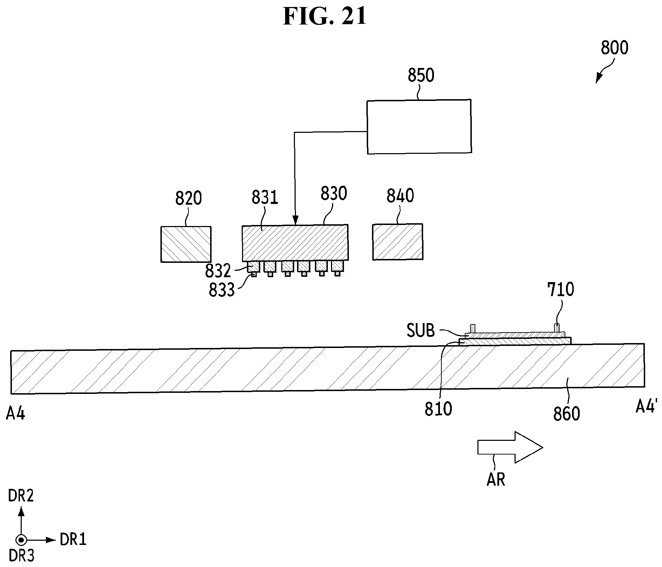

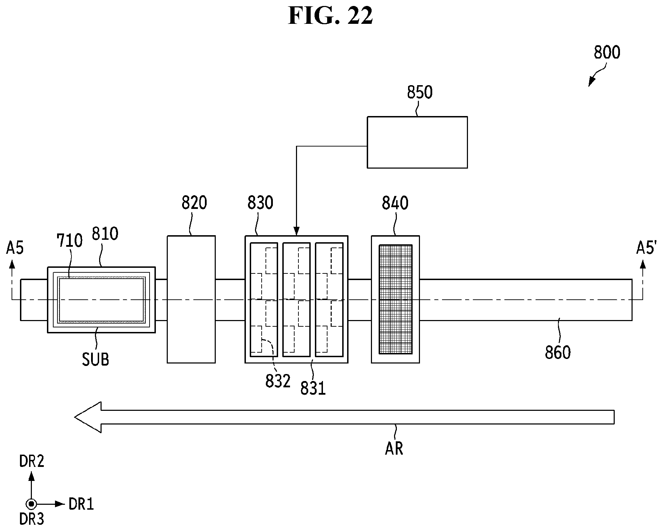

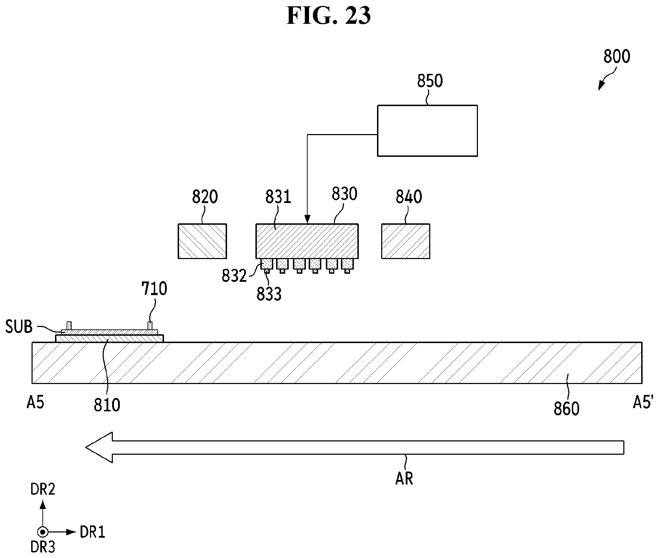

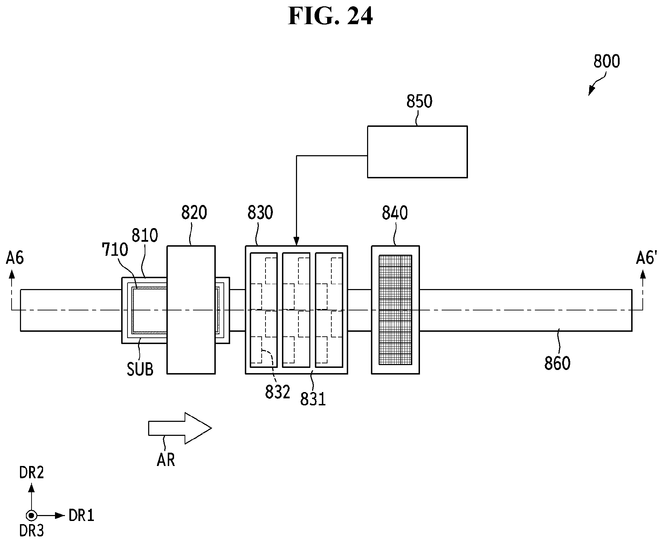

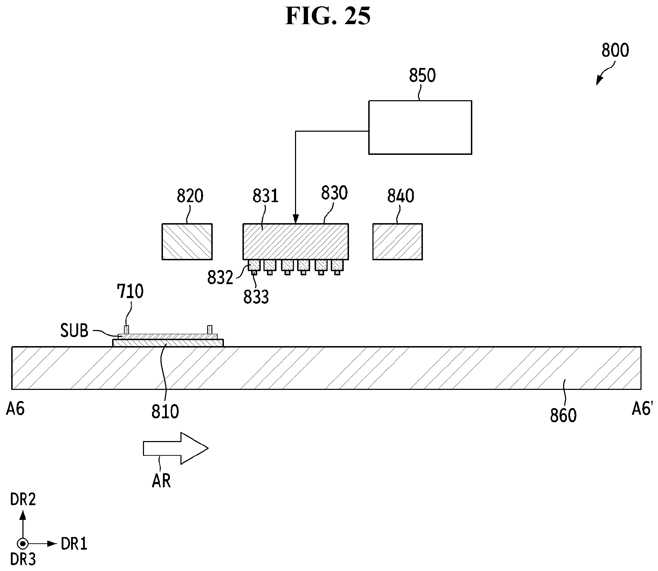

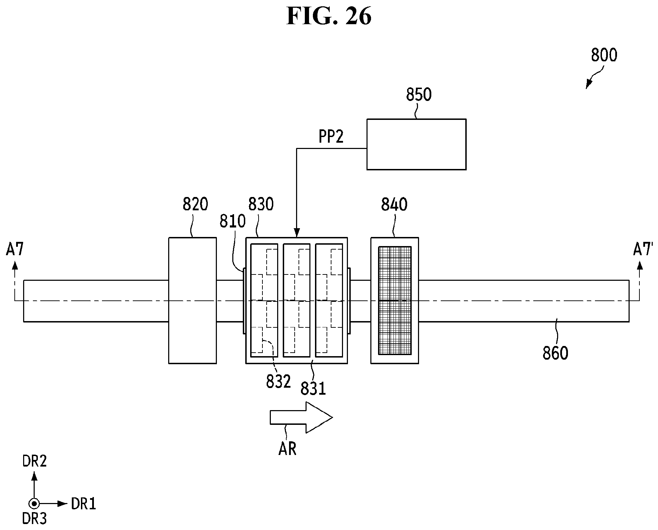

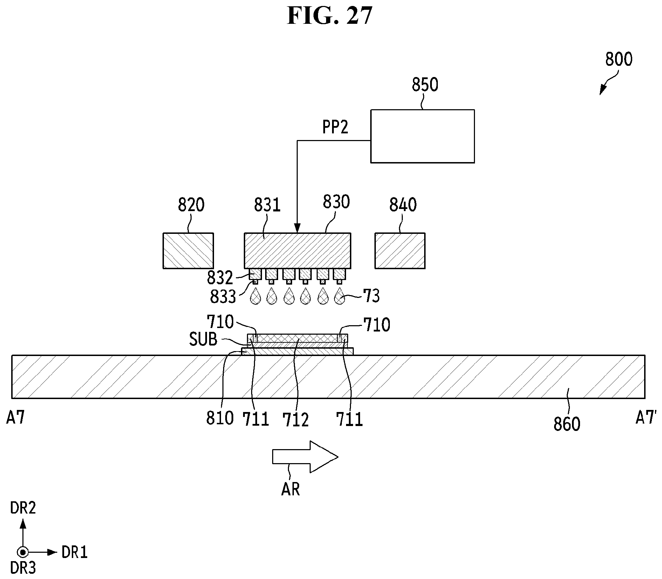

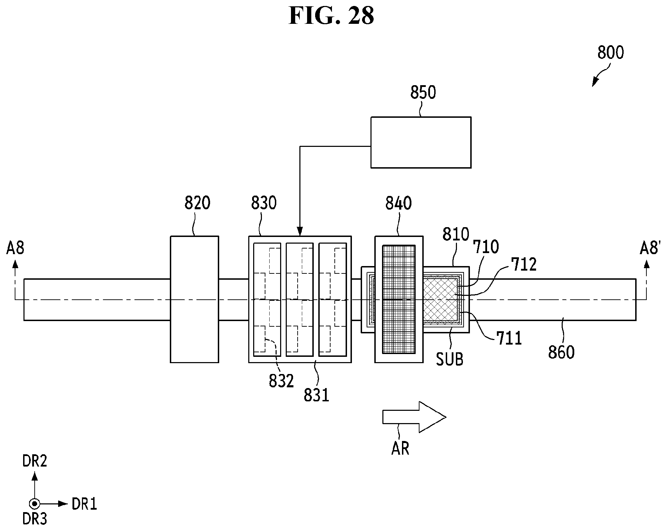

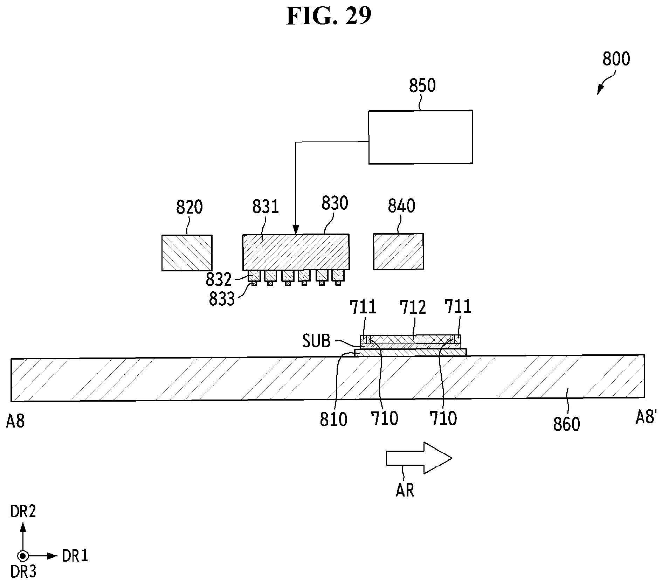

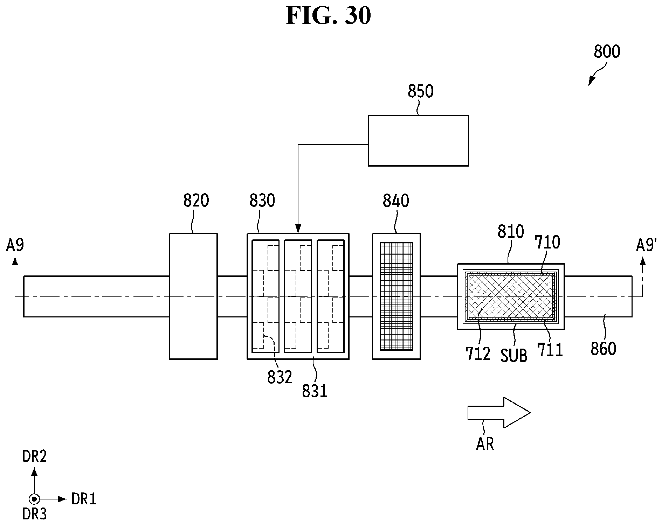

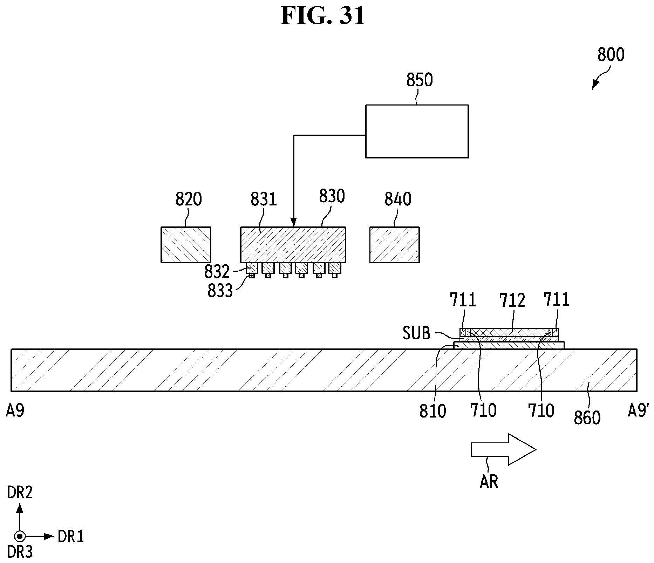

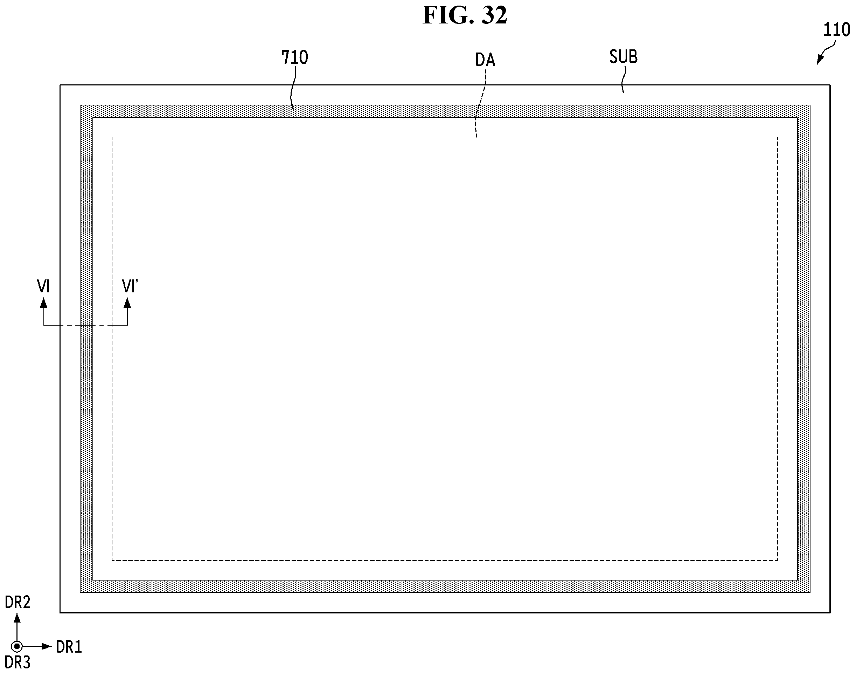

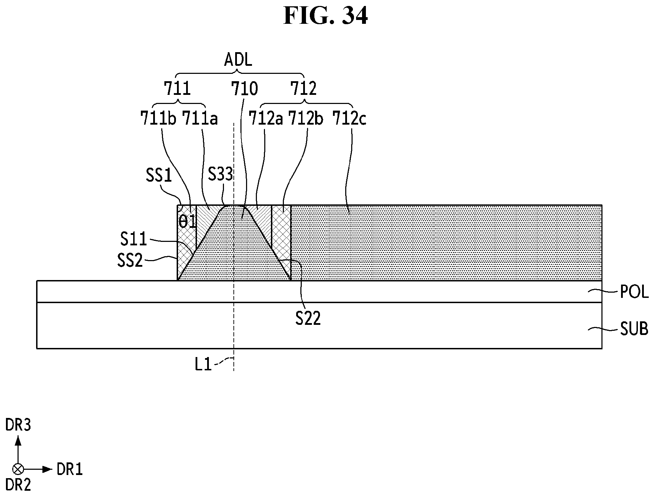

FIGS. 14 to 31 are diagrams for describing an embodiment of a method of manufacturing a display device. In an embodiment, FIGS. 14 to 31 may be diagrams for describing a method of manufacturing the display device 10 by the adhesive member forming apparatus 800 in FIGS. 12 and 13 described above, for example. Here, FIG. 15 is a cross-sectional view taken along line A1-A1' in FIG. 14, FIG. 17 is a cross-sectional view taken along line A2-A2' in FIG. 16, FIG. 19 is a cross-sectional view taken along line A3-A3' in FIG. 18, FIG. 21 is a cross-sectional view taken along line A4-A4' of FIG. 20, FIG. 23 is a cross-sectional view taken along line A5-A5' of FIG. 22, FIG. 25 is a cross-sectional view taken along line A6-A6' of FIG. 24, FIG. 27 is a cross-sectional view taken along line A7-A7' in FIG. 26, FIG. 29 is a cross-sectional view taken along line A8-A8' in FIG. 28, and FIG. 31 is a cross-sectional view taken along line A9-A9' in FIG. 30. In addition, FIG. 32 is a plan view of the substrate SUB disposed on the stage 810 in FIGS. 16 to 21, FIG. 33 is a cross-sectional view taken along line VI-VI' in FIG. 32, and FIG. 34 is a cross-sectional view of the substrate SUB disposed on the stage 810 in FIGS. 26 to 31.

An arrow AR in FIGS. 14 to 31 indicates the moving direction of the stage 810.

First, the substrate SUB on which the polarizing layer POL is formed may be disposed on the stage 810. Here, components between the substrate SUB and the polarizing layer POL in FIGS. 6 and 7 may be further disposed between the substrate SUB and the polarizing layer POL, for example.

Thereafter, as illustrated in FIGS. 14 and 15, the stage 810 on which the substrate SUB is disposed may move in the first direction DR1 along the guide rail 860. As the stage 810 passes between the alignment device 820 and the guide rail 860, the substrate SUB may be correctly aligned by the alignment device 820. In an embodiment, the alignment device 820 may capture an image of the substrate SUB on the stage 810, determine the alignment state of the substrate SUB based on the captured image of the substrate SUB, and correct the distortion of the substrate SUB according to the determination result, for example.

Subsequently, as the stage 810, which has passed by the alignment device 820, moves further in the first direction DR1 and passes between the inkjet printing device 830 and the guide rail 860 as illustrated in FIGS. 16 and 17, the intermediate adhesive layer 710 according to the first printing pattern PP1 may be formed on the substrate SUB. In an embodiment, the printing pattern providing device 850 may provide the first printing pattern PP1 to the inkjet printing device 830 before the stage 810 reaches the inkjet printing device 830 (e.g., when the stage 810 reaches the alignment device 820), for example, so that the inkjet printing device 830 may eject a raw material 70 onto the substrate SUB through the nozzles 833 corresponding to the first printing pattern PP1 from the printing pattern providing device 850. As the raw material 70 is ejected onto the substrate SUB through the nozzles 833 corresponding to the first printing pattern PP1, the intermediate adhesive layer 710 may be formed on the polarizing layer POL on the substrate SUB.

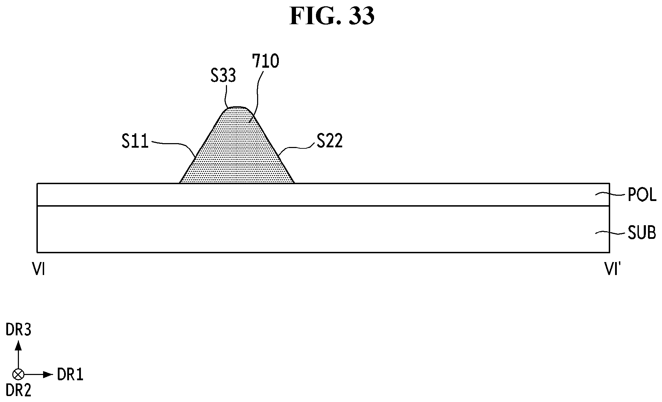

In an embodiment, the inkjet printing device 830 may be controlled such that the raw material having a maximum density (e.g., a density of 100%) is ejected from the corresponding nozzles 833 (e.g., the nozzles 833 corresponding to the first printing pattern PP1). Accordingly, as illustrated in FIGS. 32 and 33, the intermediate adhesive layer 710 surrounding the display area DA may be disposed on the polarizing layer POL on the substrate SUB.

In an embodiment, the inkjet printing device 830 may open each of the ejection holes of the corresponding nozzles 833 (e.g., the nozzles 833 corresponding to the first printing pattern PP1) to the maximum (e.g., 100% open) and may eject the raw material 70 onto the substrate SUB. In an embodiment, the opening amount of each of the nozzles 833 corresponding to the first printing pattern PP1 may be 100%, for example. Accordingly, as illustrated in FIGS. 32 and 33, the intermediate adhesive layer 710 surrounding the display area DA may be disposed on the polarizing layer POL on the substrate SUB. The amount of the raw material 70 ejected from the nozzle 833 may be controlled according to the opening amount of the nozzle 833. In an embodiment, as the opening amount of the nozzle 833 increases, the ejection amount of the raw material per unit time may increase, for example.

Next, as the stage 810, which has passed by the inkjet printing device 830, moves further in the first direction DR1 and passes between the curing device 840 and the guide rail 860 as illustrated in FIGS. 18, 19, 20, and 21, the intermediate adhesive layer 710 on the substrate SUB may be cured. In an embodiment, the curing device 840 may cure the intermediate adhesive layer 710 by irradiating the intermediate adhesive layer 710 on the substrate SUB with ultraviolet rays, for example.

Subsequently, the stage 810 that has passed by the curing device 840 may move in the opposite direction and return to the initial loading position as illustrated in FIGS. 22 and 23. In an embodiment, the stage 810 may move along the first reverse direction on the guide rail 860 and move to the front end of the alignment device 820, for example. When the stage 810 moves on the guide rail 860 along the first reverse direction, the alignment device 820, the inkjet printing device 830, and the curing device 840 may be maintained in a non-driven state.

Thereafter, as illustrated in FIGS. 24 and 25, as the stage 810 passes between the alignment device 820 and the guide rail 860, the substrate SUB may be correctly aligned by the alignment device 820. In an embodiment, the alignment device 820 may capture an image of the substrate SUB on the stage 810, determine the alignment state of the substrate SUB based on the captured image of the substrate SUB, and correct the distortion of the substrate SUB according to the determination result, for example.

Next, as the stage 810, which has passed by the alignment device 820, moves further in the first direction DR1 and passes between the inkjet printing device 830 and the guide rail 860 as illustrated in FIGS. 26 and 27, the peripheral adhesive layer (e.g., the first peripheral adhesive layer 711 and the second peripheral adhesive layer 712) according to the second printing pattern PP2 may be formed on the substrate SUB. In an embodiment, the printing pattern providing device 850 may provide the second printing pattern PP2 to the inkjet printing device 830 before the stage 810 reaches the inkjet printing device 830 (e.g., when the stage 810 reaches the alignment device 820), for example, so that the inkjet printing device 830 may eject a raw material 73 onto the substrate SUB through the nozzles 833 corresponding to the second printing pattern PP2 from the printing pattern providing device 850. As the raw material 73 is ejected onto the substrate SUB through the nozzles 833 corresponding to the second printing pattern PP2, the first peripheral adhesive layer 711 and the second peripheral adhesive layer 712 may be formed on the polarizing layer POL on the substrate SUB.

In an embodiment, the inkjet printing device 830 may eject the raw material 73 onto the substrate SUB by adjusting the density of the raw material 73 ejected from the corresponding nozzles 833 (e.g., the nozzles 833 corresponding to the second printing pattern PP2) or the opening degree of the ejection holes of the corresponding nozzles 833 (e.g., the nozzles 833 corresponding to the second printing pattern PP2). Accordingly, and as illustrated in FIG. 34, the first peripheral adhesive layer 711 and the second peripheral adhesive layer 712 may be disposed on the polarizing layer POL on the substrate SUB. In an embodiment, the first peripheral adhesive layer 711 may be formed on the first side surface S11 of the intermediate adhesive layer 710, and the second peripheral adhesive layer 712 may be formed on the second side surface S22 of the intermediate adhesive layer 710 and the display area DA, for example. At this time, the second peripheral adhesive layer 712 may entirely fill the area surrounded by the intermediate adhesive layer 710.

In an embodiment, in order to form the peripheral adhesive layers 711 and 712, the density of the raw material 73 ejected from the nozzle 833 corresponding to the first-first sub-adhesive layer 711a may be 20% of the maximum density, the density of the raw material 73 ejected from the nozzle 833 corresponding to the first-second sub-adhesive layer 711b may be 80% of the maximum density, the density of the raw material 73 ejected from the nozzle 833 corresponding to the second-first sub-adhesive layer 712a may be 30% of the maximum density, the density of the raw material 73 ejected from the nozzle 833 corresponding to the second-second sub-adhesive layer 712b may be 80% of the maximum density, and the raw material 73 ejected from the nozzle 833 corresponding to the second-third sub-adhesive layer 712c may be ejected at the maximum density. In this way, the density of the raw material 73 ejected from each of the nozzles 833 corresponding to each sub-adhesive layer may be controlled, so that the first peripheral adhesive layer 711 and the second peripheral adhesive layer 712 having the shape illustrated in FIG. 34 may be formed, for example.

In an embodiment, in order to form the peripheral adhesive layers 711 and 712, the opening amount of the nozzle 833 corresponding to the first-first sub-adhesive layer 711a may be 20% of the maximum opening amount, the opening amount of the nozzle 833 corresponding to the first-second sub-adhesive layer 711b may be 80% of the maximum opening amount, the opening amount of the nozzle 833 corresponding to the second-first sub-adhesive layer 712a may be 30% of the maximum opening amount, the opening amount of the nozzle 833 corresponding to the second-second sub-adhesive layer 712b may be 80% of the maximum opening amount, and the nozzle 833 corresponding to the second-third sub-adhesive layer 712c may be maximally open (e.g., 100%). In this way, the opening amount of each of the nozzles 833 corresponding to each sub-adhesive layer may be adjusted differently, so that the first peripheral adhesive layer 711 and the second peripheral adhesive layer 712 having the shape illustrated in FIG. 34 may be formed, for example.

Next, as the stage 810, which has passed by the inkjet printing device 830, moves further in the first direction DR1 and passes between the curing device 840 and the guide rail 860 as illustrated in FIGS. 28, 29, 30, and 31, the first peripheral adhesive layer 711 and the second peripheral adhesive layer 712 on the substrate SUB may be cured. In an embodiment, the curing device 840 may cure the first peripheral adhesive layer 711 and the second peripheral adhesive layer 712 by irradiating the first peripheral adhesive layer 711 and the second peripheral adhesive layer 712 on the substrate SUB with ultraviolet rays, for example.

In an embodiment, the accumulated amount of ultraviolet rays irradiated when the intermediate adhesive layer 710 is cured and the accumulated amount of ultraviolet rays irradiated when the peripheral adhesive layers 711 and 712 are cured may be different from each other. In an embodiment, the accumulated amount of ultraviolet rays irradiated from the curing device 840 when the peripheral adhesive layer (e.g., the first peripheral adhesive layer 711 and the second peripheral adhesive layer 712) is cured may be greater than the accumulated amount of ultraviolet rays irradiated from the curing device 840 when the intermediate adhesive layer 710 is cured, for example. When the peripheral adhesive layer (e.g., the first peripheral adhesive layer 711 and the second peripheral adhesive layer 712) is cured, the intermediate adhesive layer 710 may also be further cured.

In an embodiment, when the densities of the raw materials 70 and 73 ejected on the substrate SUB is controlled as described above, the adhesive member ADL having the shape illustrated in FIGS. 8 and 9 may be formed on the polarizing layer POL. In other words, when the densities of the raw materials 70 and 73 ejected from the nozzle 833 are controlled to form the adhesive member ADL, the adhesive member ADL may include the intermediate adhesive layer 710, the first-first sub-adhesive layer 711a, the first-second sub-adhesive layer 711b, the second-first sub-adhesive layer 712a, the second-second sub-adhesive layer 712b, and the second-third sub-adhesive layer 712c distinguished from each other by interfaces.

In an embodiment, when the ejection amounts of the raw materials 70 and 73 provided on the substrate SUB are controlled as described above, the adhesive member ADL having the shape illustrated in FIGS. 10 and 11 may be formed on the polarizing layer POL. In other words, when the ejection amounts of the raw materials 70 and 73 provided from the nozzle 833 are controlled to form the adhesive member ADL, the adhesive member ADL may include the intermediate adhesive layer 710, the first-first sub-adhesive layer 711a, the first-second sub-adhesive layer 711b, the second-first sub-adhesive layer 712a, the second-second sub-adhesive layer 712b, and the second-third sub-adhesive layer 712c formed integrally without distinction of interfaces.

In an embodiment, as described above, when the densities of the raw materials 70 and 73 or the ejection amounts of the raw materials 70 and 73 are controlled and the adhesive member ADL is formed, the top surface SS1 of the adhesive member ADL may be flattened. In an embodiment, the top surface SS1 of the edge of the adhesive member ADL may be flattened, for example. In other words, the top surface SS1 of the adhesive member ADL may be flattened to form an angle of 90 degrees to 135 degrees with respect to the side surface SS2 of the adhesive member ADL. In an embodiment, the interior angle θ1 described above may be 90 degrees. Accordingly, when the adhesive member ADL and the cover window CSUB are bonded to each other, adhesion between the adhesive member ADL and the cover window CSUB may be improved at the edge of the adhesive member ADL. Accordingly, a gap (e.g., an air gap) may be prevented from being defined between the adhesive member ADL and the cover window CSUB at the edge of the adhesive member ADL. As a result, spot defects may be prevented from being visually recognized around the edge of the adhesive member ADL, so that the image quality of the display device 10 may be improved.

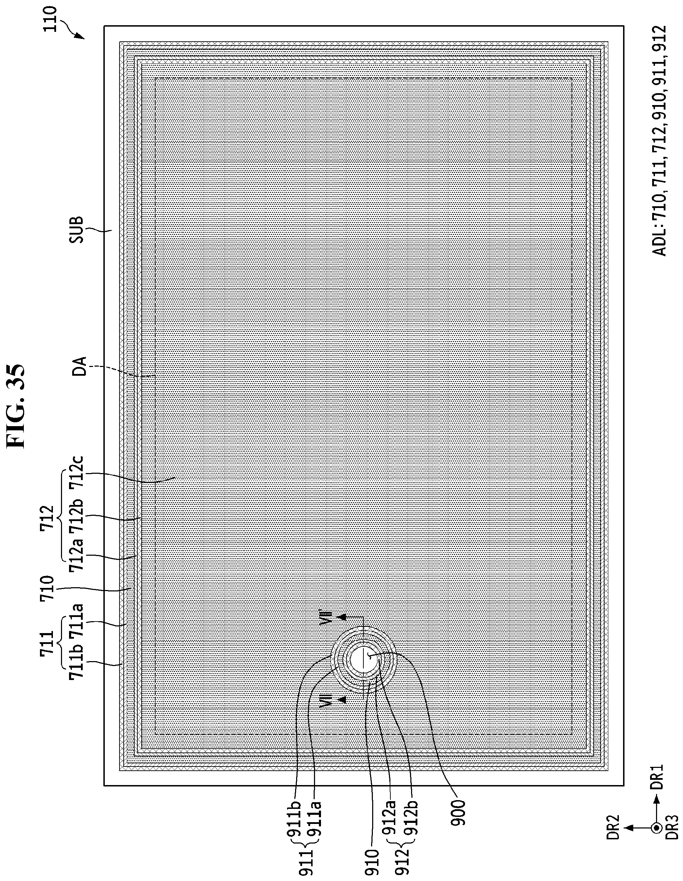

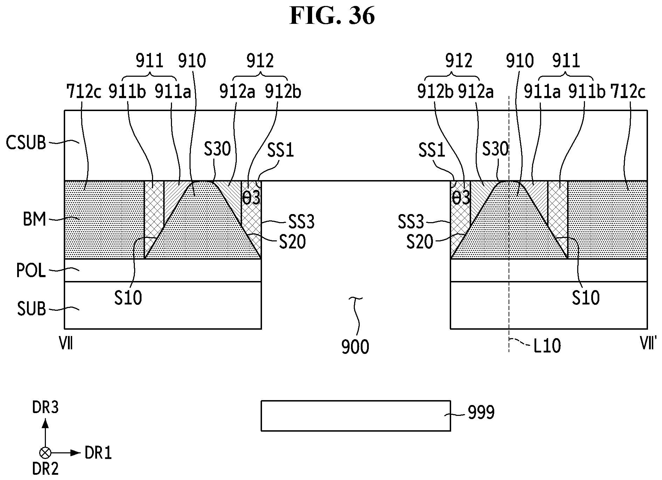

FIG. 35 is a schematic plan view of an embodiment of the display panel 110 including the adhesive member ADL, and FIG. 36 is a cross-sectional view taken along line VII-VII' of FIG. 35.

The display device in FIGS. 35 and 36 is different from the display device in FIGS. 8 and 9 described above in that a hole 900 penetrating the substrate SUB, an intermediate adhesive layer 910 (hereinafter referred to as the second intermediate adhesive layer 910) disposed around the hole 900, and peripheral adhesive layers (hereinafter referred to as a third peripheral adhesive layer 911 and a fourth peripheral adhesive layer 912) are further included, so that the difference will be mainly described as follows.

As illustrated in FIGS. 35 and 36, the display device in an embodiment may further include the hole 900 penetrating the substrate SUB, the polarizing layer POL, and the adhesive member ADL in the display area DA. In an embodiment, components between the substrate SUB and the polarizing layer POL in FIGS. 6 and 7 may be further disposed between the substrate SUB and the polarizing layer POL, so that in this case, the hole 900 may further penetrate insulating films among the components between the substrate SUB and the polarizing layer POL.

An electronic component 999 that overlaps the hole 900 may be disposed below the hole 900. In an embodiment, the electronic component 999 may include at least one of a camera or various sensors, for example.

In plan view as illustrated in FIG. 35, the hole 900 may have a circular shape.

As illustrated in FIG. 35, the adhesive member ADL may include the intermediate adhesive layer 710 (e.g., the first intermediate adhesive layer 710), the first peripheral adhesive layer 711, the second peripheral adhesive layer 712, the second intermediate adhesive layer 910, the third peripheral adhesive layer 911, and the fourth peripheral adhesive layer 912.

The first intermediate adhesive layer 710, the first peripheral adhesive layer 711, and the second peripheral adhesive layer 712 in FIG. 35 are the same as the intermediate adhesive layer 710, the first peripheral adhesive layer 711, and the second peripheral adhesive layer 712 in FIGS. 8 and 9 described above, respectively.

In plan view as illustrated in FIG. 35, the second intermediate adhesive layer 910 may have a closed curve shape surrounding the hole 900. The second intermediate adhesive layer 910 may be disposed between the third peripheral adhesive layer 911 and the fourth peripheral adhesive layer 912.

In cross-sectional view as illustrated in FIG. 36, the second intermediate adhesive layer 910 may have a width that gradually decreases along the direction (e.g., the third direction DR3) toward the cover window CSUB. In an embodiment, the second intermediate adhesive layer 910 may have a triangular cross section, for example. In an embodiment, the top surface of the second intermediate adhesive layer 910 may have a round shape (or parabolic shape). In an embodiment, the top surface of the second intermediate adhesive layer 910 may be a surface facing (or in contact with) the cover window CSUB, so that a top surface S30 of the second intermediate adhesive layer 910 may have a round shape (or parabolic shape) convex toward the cover window CSUB, for example.

In an embodiment, each of a first side surface S10 (e.g., the outer surface of the second intermediate adhesive layer 910) and a second side surface S20 (e.g., the inner surface of the second intermediate adhesive layer 910) facing each other of the second intermediate adhesive layer 910 may form an inclined diagonal shape. The center of the second intermediate adhesive layer 910 may pass through the center (e.g., the center of the top surface S30 of the second intermediate adhesive layer 910) between the first side surface S10 of the second intermediate adhesive layer 910 and the second side surface S20 of the intermediate adhesive layer 710, and may overlap an imaginary extension line L10 parallel to the side surface of the adhesive member ADL (or parallel to the third direction DR3). The first side surface S10 and the second side surface S20 of the second intermediate adhesive layer 910 may have a symmetrical shape with respect to the extension line L10 described above.

The third peripheral adhesive layer 911 may be disposed on one side of the second intermediate adhesive layer 910. In an embodiment, as illustrated in FIG. 36, the third peripheral adhesive layer 911 may be disposed between the second-third sub-adhesive layer 712c and the first side surface S10 of the second intermediate adhesive layer 910, for example.

The third peripheral adhesive layer 911 may include a plurality of third sub-adhesive layers having different densities. In an embodiment, the plurality of third sub-adhesive layers 911a and 911b may have higher densities as they are disposed farther from the second intermediate adhesive layer 910, for example. As a predetermined example, the plurality of third sub-adhesive layers 911a and 911b may have higher densities as they are disposed farther from the center (or the extension line L10) of the second intermediate adhesive layer 910.

In an embodiment, the third peripheral adhesive layer 911 may include the third-first sub-adhesive layer 911a and the third-second sub-adhesive layer 911b having different densities. The third-first sub-adhesive layer 911a may be disposed between the second intermediate adhesive layer 910 and the third-second sub-adhesive layer 911b. The third-second sub-adhesive layer 911b may be disposed between the third-first sub-adhesive layer 911a and the second-third sub-adhesive layer 712c. The third-first sub-adhesive layer 911a among the plurality of third sub-adhesive layers 911a and 911b may be disposed closer to the center (or the extension line L10) of the second intermediate adhesive layer 910, and the third-second sub-adhesive layer 911b among the plurality of third sub-adhesive layers 911a and 911b may be disposed farther from the center (or the extension line L10) of the second intermediate adhesive layer 910. In other words, the third-second sub-adhesive layer 911b may be disposed farther from the center (or the extension line L10) of the second intermediate adhesive layer 910 than the third-first sub-adhesive layer 911a.

In an embodiment, the density of the third-second sub-adhesive layer 911b may be higher than the density of the third-first sub-adhesive layer 911a. In other words, the third-first sub-adhesive layer 911a disposed closer to the second intermediate adhesive layer 910 may have a relatively lower density, and the third-second sub-adhesive layer 911b disposed farther from the second intermediate adhesive layer 910 may have a relatively higher density.

The fourth peripheral adhesive layer 912 may be disposed on an opposite side of the second intermediate adhesive layer 910. In an embodiment, as illustrated in FIG. 36, the fourth peripheral adhesive layer 912 may be disposed between the hole 900 (or the inner wall of the hole 900) and the second side surface S20 of the second intermediate adhesive layer 910, for example.

The fourth peripheral adhesive layer 912 may include a plurality of fourth sub-adhesive layers 912a and 912b having different densities. In an embodiment, the plurality of fourth sub-adhesive layers 912a and 912b may have higher densities as they are disposed farther from the second intermediate adhesive layer 910, for example. As a predetermined example, the plurality of fourth sub-adhesive layers 912a and 912b may have higher densities as they are disposed farther from the center (or the extension line L1) of the second intermediate adhesive layer 910.

In an embodiment, the fourth peripheral adhesive layer 912 may include a fourth-first sub-adhesive layer 912a and a fourth-second sub-adhesive layer 912b having different densities. The fourth-first sub-adhesive layer 912a may be disposed between the second intermediate adhesive layer 910 and the fourth-second sub-adhesive layer 912b. The fourth-second sub-adhesive layer 912b may be disposed between the fourth-first sub-adhesive layer 912a and the hole 900 (or the inner wall of the hole 900). The fourth-first sub-adhesive layer 912a among the plurality of fourth sub-adhesive layers 912a and 912b may be disposed relatively close to the center (or the extension line L10) of the second intermediate adhesive layer 910, and the fourth-second sub-adhesive layer 912b among the plurality of fourth sub-adhesive layers 912a and 912b may be disposed relatively far from the center (or the extension line L10) of the second intermediate adhesive layer 910. In other words, the fourth-second sub-adhesive layer 912b may be disposed farther from the center (or the extension line L10) of the second intermediate adhesive layer 910 than the fourth-first sub-adhesive layer 912a.

In an embodiment, the density of the fourth-second sub-adhesive layer 912b may be higher than the density of the fourth-first sub-adhesive layer 912a. In other words, the fourth-first sub-adhesive layer 912a disposed close to the second intermediate adhesive layer 910 may have a relatively lower density, and the fourth-second sub-adhesive layer 912b disposed far from the second intermediate adhesive layer 910 may have a relatively higher density.

In an embodiment, an angle θ3 defined between a side surface SS3 (e.g., the inner wall of the hole 900) of the fourth-second sub-adhesive layer 912b and the top surface SS1 (e.g., the top surface of the adhesive member ADL) of the fourth-second sub-adhesive layer 912b may be 90 degrees to 135 degrees. In an embodiment, the interior angle θ3 described above may be 90 degrees.

In an embodiment, the density of the second intermediate adhesive layer 910 may be different from the density of at least one sub-adhesive layer included in the third peripheral adhesive layer 911. In an embodiment, the density of the second intermediate adhesive layer 910 may be higher than the density of the third-first sub-adhesive layer 911a, for example. Additionally, the density of the second intermediate adhesive layer 910 may be higher than the density of the third-second sub-adhesive layer 911b.

In an embodiment, the density of the second intermediate adhesive layer 910 may be different from the density of at least one sub-adhesive layer included in the fourth peripheral adhesive layer 912. In an embodiment, the density of the second intermediate adhesive layer 910 may be higher than the density of the fourth-first sub-adhesive layer 912a, for example. Additionally, the density of the second intermediate adhesive layer 910 may be higher than the density of the fourth-second sub-adhesive layer 912b.

In an embodiment, the density of the second intermediate adhesive layer 910 may be higher than the density of the sub-adhesive layer included in the third peripheral adhesive layer 911 or the fourth peripheral adhesive layer 912.

In an embodiment, the fourth-second sub-adhesive layer 912b may surround the hole 900 in a plan view as illustrated in FIG. 35. Additionally, in a plan view as illustrated in FIG. 35, the fourth-first sub-adhesive layer 912a may surround the hole 900 and the fourth-second sub-adhesive layer 912b. In addition, in a plan view as illustrated in FIG. 35, the second intermediate adhesive layer 910 may surround the hole 900, the fourth-second sub-adhesive layer 912b, and the fourth-first sub-adhesive layer 912a. In addition, in a plan view as illustrated in FIG. 35, the third-first sub-adhesive layer 911a may surround the hole 900, the fourth-second sub-adhesive layer 912b, the fourth-first sub-adhesive layer 912a, and the second intermediate adhesive layer 910. In addition, in a plan view as illustrated in FIG. 35, the third-second sub-adhesive layer 911b may surround the hole 900, the fourth-second sub-adhesive layer 912b, the fourth-first sub-adhesive layer 912a, the second intermediate adhesive layer 910, and the third-first sub-adhesive layer 911a.

In an embodiment, the third peripheral adhesive layer 911 and the fourth peripheral adhesive layer 912 may not be connected to each other. In other words, the third peripheral adhesive layer 911 and the fourth peripheral adhesive layer 912 may be separated from each other by the intermediate adhesive layer 710 therebetween. Accordingly, the third-first sub-adhesive layer 911a and the fourth-first sub-adhesive layer 912a may not be connected to each other but may be separated, for example.

In an embodiment, the third peripheral adhesive layer 911 and the fourth peripheral adhesive layer 912 may not be disposed between the top surface of the second intermediate adhesive layer 910 and the cover window CSUB. In an embodiment, the top surface (e.g., the center of the top surface) of the intermediate adhesive layer 710 and the cover window CSUB may be in contact (e.g., direct contact) with each other, for example.

In an embodiment, the second intermediate adhesive layer 910 may be formed through the same process as the intermediate adhesive layer 710 described above. In an embodiment, the second intermediate adhesive layer 910 and the intermediate adhesive layer 710 may be formed substantially simultaneously through the processes illustrated in FIGS. 14 to 21 described above, for example.

In an embodiment, the third peripheral adhesive layer 911 and the fourth peripheral adhesive layer 912 may be formed through the same process as the first peripheral adhesive layer 711 and second peripheral adhesive layer 712 described above. In an embodiment, the third peripheral adhesive layer 911, the fourth peripheral adhesive layer 912, the first peripheral adhesive layer 711, and the second peripheral adhesive layer 712 may be formed substantially simultaneously through the processes illustrated in FIGS. 22 to 31 described above, for example.

In an embodiment, as described above, when the densities of the raw materials 70 and 73 or the ejection amounts of the raw materials 70 and 73 are controlled and the adhesive member ADL is formed, the top surface SS1 of the adhesive member ADL may be flattened. In an embodiment, the top surface SS1 of the edge of the adhesive member ADL may be flattened, for example. In other words, the top surface SS1 of the adhesive member ADL may be flattened to form an angle of 90 degrees to 135 degrees with respect to the side surface SS3 of the adhesive member ADL. In an embodiment, the interior angle θ1 described above may be 90 degrees. Accordingly, when the adhesive member ADL and the cover window CSUB are bonded to each other, adhesion between the adhesive member ADL and the cover window CSUB may be improved at the edge of the hole 900. Accordingly, a gap (e.g., an air gap) may be prevented from being defined between the adhesive member ADL and the cover window CSUB at the edge of the hole 900. As a result, spot defects may be prevented from being visually recognized around the edge of the hole 900, and the image quality of the display device 10 may be improved.

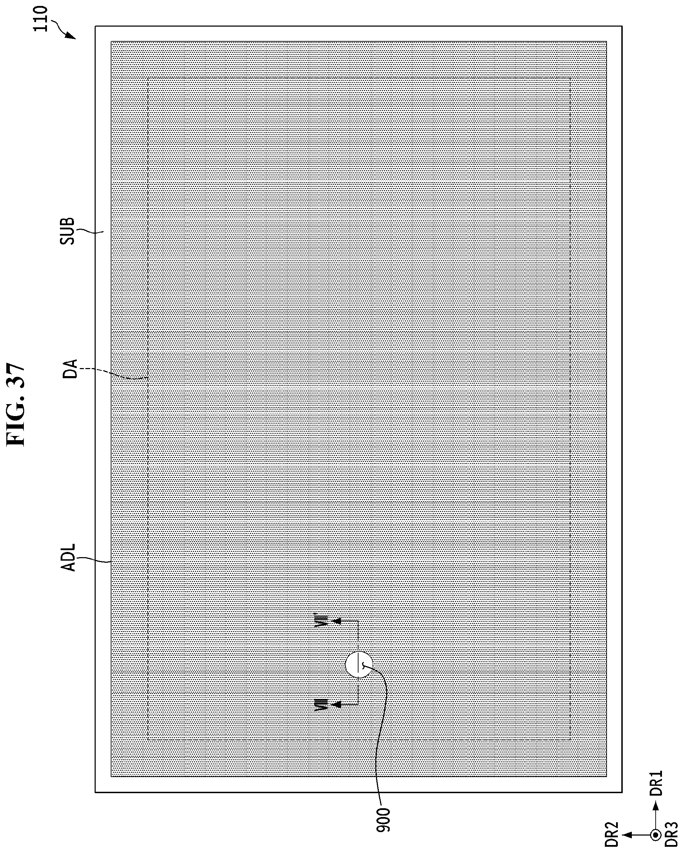

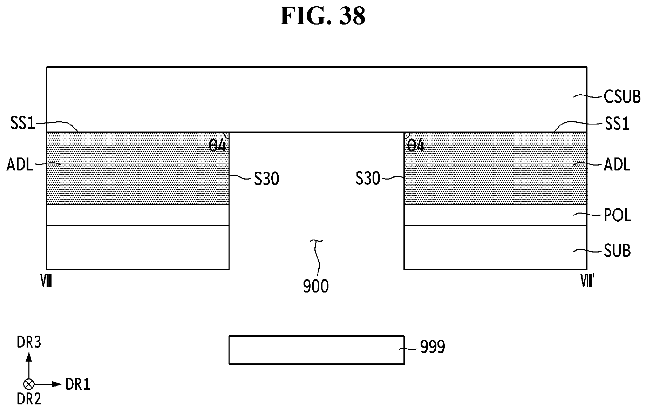

FIG. 37 is a schematic plan view of the display panel 110 including the adhesive member ADL in an embodiment, and FIG. 38 is a cross-sectional view taken along line VIII-VIII' of FIG. 37.

The display device in FIGS. 37 and 38 is different from the display device in FIGS. 10 and 11 described above in that the hole 900 penetrating the substrate SUB is further included, so that the difference will be mainly described as follows.

As illustrated in FIGS. 37 and 38, the display device in an embodiment may further include the hole 900 penetrating the substrate SUB, the polarizing layer POL, and the adhesive member ADL in the display area DA. In an embodiment, components between the substrate SUB and the polarizing layer POL in FIGS. 6 and 7 may be further disposed between the substrate SUB and the polarizing layer POL, so that in this case, the hole 900 may further penetrate insulating films among the components between the substrate SUB and the polarizing layer POL, for example.

In plan view as illustrated in FIG. 37, the hole 900 may have a circular shape.

In an embodiment, as illustrated in FIG. 38, an angle θ4 defined between the inner wall SS3 of the hole 900 and the top surface SS1 of the adhesive member ADL may be 90 degrees to 135 degrees. In an embodiment, the interior angle θ4 described above may be 90 degrees.

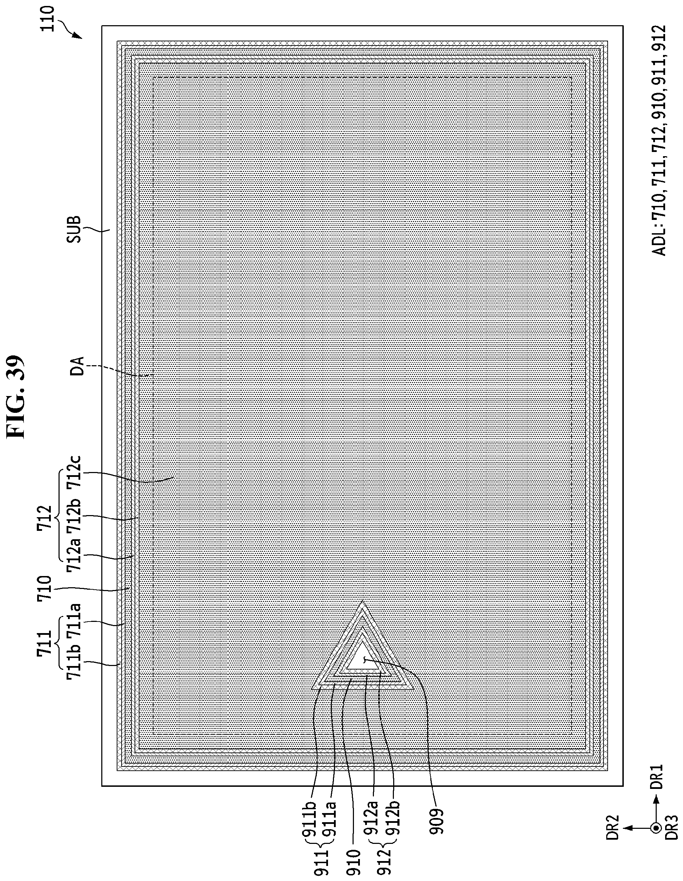

FIG. 39 is a schematic plan view of the display panel 110 including the adhesive member ADL.

The display device in FIG. 39 is different from the display device in FIGS. 35 and 36 described above in terms of the shape of the hole 900, and the difference will be mainly described as follows.

In plan view as illustrated in FIG. 39, the hole 900 may have a triangular shape.

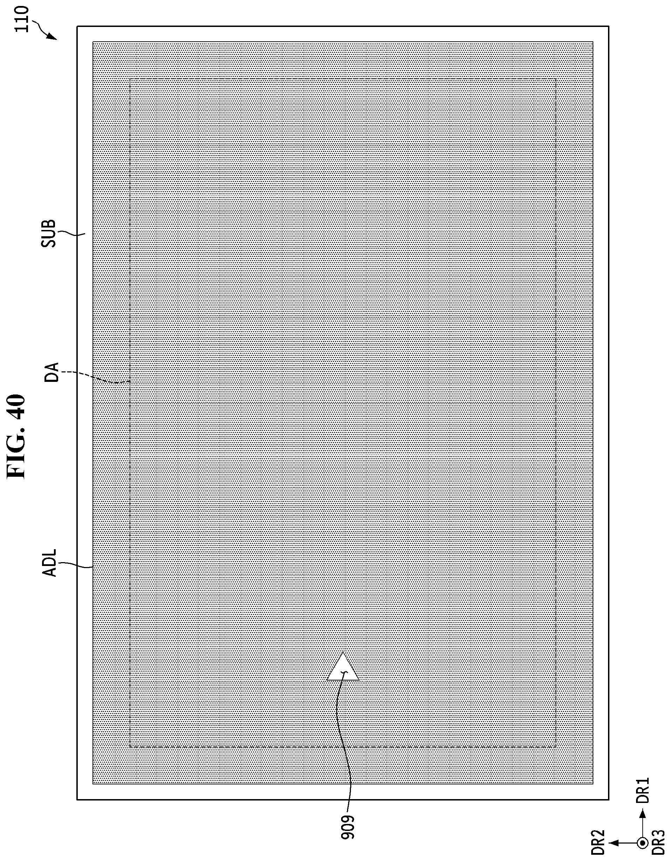

FIG. 40 is a schematic plan view of the display panel 110 including the adhesive member ADL.

The display device in FIG. 40 is different from the display device in FIGS. 37 and 38 described above in terms of the shape of the hole 900, and the difference will be mainly described as follows.

In plan view as illustrated in FIG. 40, the hole 909 may have a triangular shape.

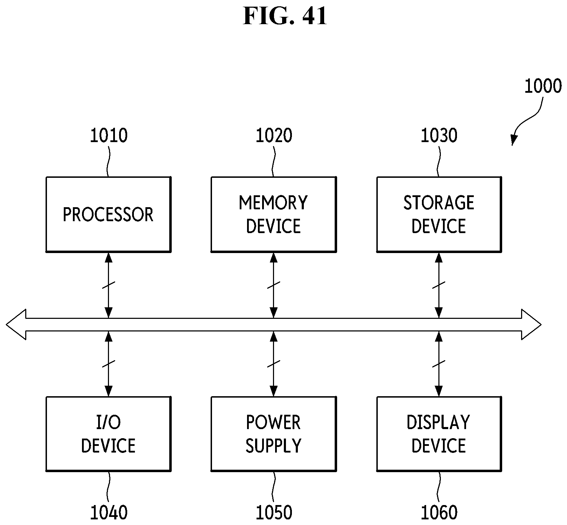

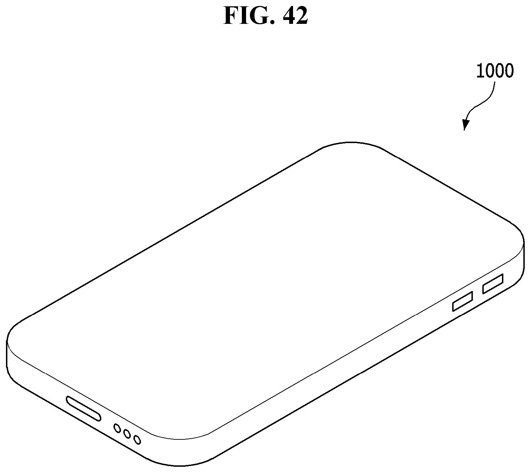

FIG. 41 is a block diagram illustrating an electronic device according to an embodiment. FIG. 42 is a view illustrating an embodiment of the electronic device of FIG. 41 implemented as a smartphone.

Referring to FIGS. 41 and 42, in an embodiment, an electronic device 1000 may include a processor 1010, a memory device 1020, a storage device 1030, an input/output ("I/O") device 1040, a power supply 1050, and a display device 1060. Here, the display device 1060 may correspond to the display device 10 of FIG. 1. The electronic device 1000 may further include a plurality of ports for communicating with a video card, a sound card, a memory card, a universal serial bus ("USB") device, or the like. In an embodiment, the electronic device 1000 may be implemented as a television. In another embodiment, the electronic device 1000 may be implemented as a smart phone. However, embodiments are not limited thereto, in another embodiment, the electronic device 1000 may be implemented as a cellular phone, a video phone, a smart pad, a smart watch, a tablet personal computer ("PC"), a car navigation system, a computer monitor, a laptop, a head disposed (e.g., mounted) display ("HMD"), or the like.

The processor 1010 may perform various computing functions. In an embodiment, the processor 1010 may be a microprocessor, a central processing unit ("CPU"), an application processor ("AP"), or the like. The processor 1010 may be coupled to other components via an address bus, a control bus, a data bus, or the like. In an embodiment, the processor 1010 may be coupled to an extended bus such as a peripheral component interconnection ("PCI") bus.

The memory device 1020 may store data for operations of the electronic device 1000. In an embodiment, the memory device 1020 may include at least one non-volatile memory device such as an erasable programmable read-only memory ("EPROM") device, an electrically erasable programmable read-only memory ("EEPROM") device, a flash memory device, a phase change random access memory ("PRAM") device, a resistance random access memory ("RRAM") device, a nano floating gate memory ("NFGM") device, a polymer random access memory ("PoRAM") device, a magnetic random access memory ("MRAM") device, a ferroelectric random access memory ("FRAM") device, or the like, and/or at least one volatile memory device such as a dynamic random access memory ("DRAM") device, a static random access memory ("SRAM") device, a mobile DRAM device, or the like.

In an embodiment, the storage device 1030 may include a solid state drive ("SSD") device, a hard disk drive ("HDD") device, a CD-ROM device, or the like. In an embodiment, the I/O device 1040 may include an input device such as a keyboard, a keypad, a mouse device, a touchpad, a touch-screen, or the like, and an output device such as a printer, a speaker, or the like.

The power supply 1050 may provide power for operations of the electronic device 1000. The power supply 1050 may provide power to the display device 1060. The display device 1060 may be coupled to other components via the buses or other communication links. In an embodiment, the display device 1060 may be included in the I/O device 1040.

In an embodiment the electronic device may be implemented as a smartphone. However the embodiments of the present invention may be exemplary and may not be limited to this. For example, the electronic device 1000 may be implemented as a mobile phone, a video phone, a smart pad, a smart watch, a television, a tablet PC, a vehicle display, a computer monitor, a notebook computer, a head-mounted display device, etc. In addition, the electronic device 1000 may be a television, a monitor, a notebook computer, or a tablet. In addition, the electronic device 1000 may be a car.

It will be able to be understood by one of ordinary skill in the art to which the invention belongs that the invention may be implemented in other predetermined forms without changing the technical spirit or essential features of the invention. Therefore, it is to be understood that the embodiments described above are illustrative rather than being restrictive in all features. It is to be understood that the scope of the invention are defined by the claims rather than the detailed description described above and all modifications and alterations derived from the claims .

## Claims

1. A display device (10) comprising:
a substrate (SUB);
a pixel electrode (PXE) on the substrate (SUB);
a light-emitting layer (EL) on the pixel electrode (PXE);
a common electrode (CE) on the light-emitting layer (EL);
an encapsulation layer (TFE) on the common electrode (CE);
a polarizing layer (POL) on the encapsulation layer (TFE);
an adhesive member (ADL) on the polarizing layer (POL) and including a side surface (SS2) and a top surface (SS1);
a cover window (CSUB) on the adhesive member (ADL); and
a light blocking layer (BM) disposed next to the adhesive member (ADL), between the polarizing layer (POL) and the cover window (CSUB),
wherein an angle (θ1) defined between the side surface (SS2) of the adhesive member (ADL) facing the light blocking layer (BM) and the top surface (SS1) of the adhesive member (ADL) facing the cover window (CSUB) is 90 degrees to 135 degrees.

2. The display device (10) of claim 1, wherein an angle (θ2) defined between the top surface (SS1) of the adhesive member (ADL) and the side surface (SS2) of the adhesive member (ADL) at an edge of the adhesive member (ADL) is 90 degrees to 135 degrees.

3. The display device (10) of claim 1 or 2, wherein a gap is defined between the adhesive member (ADL) and the light blocking layer (BM).

4. The display device (10) of at least one of claims 1 to 3, wherein in a plan view, the gap surrounds the adhesive member (ADL).

5. The display device (10) of at least one of claims 1 to 4, wherein in a plan view, an edge of the adhesive member (ADL) surrounds a display area of the substrate (SUB).

6. The display device (10) of at least one of claims 1 to 5, wherein the adhesive member (ADL) comprises:
a first intermediate adhesive layer (710) having a closed curve shape surrounding a display area of the substrate (SUB);
a first peripheral adhesive layer (711) disposed on a first side surface (S11) of the first intermediate adhesive layer (710); and
a second peripheral adhesive layer (712) disposed on a second side surface (S22) of the first intermediate adhesive layer (710).

7. The display device (10) of claim 6, wherein the first peripheral adhesive layer (711) comprises a plurality of first sub-adhesive layers (711a, 711b) having different densities.

8. The display device (10) of claim 7, wherein the plurality of first sub-adhesive layers (711a, 711b) have higher densities as the plurality of first sub-adhesive layers (711a, 711b) is disposed farther from a center of the first intermediate adhesive layer (710).

9. The display device (10) of at least one of claims 6 to 8, wherein the first peripheral adhesive layer (711) comprises a plurality of second sub-adhesive layers (712a, 712b, 712c) having different densities.

10. The display device (10) of claim 9, wherein the plurality of second sub-adhesive layers (712a, 712b, 712c) have higher densities as the plurality of second sub-adhesive layers (712a, 712b, 712c) is disposed farther from a center of the first intermediate adhesive layer (710).

11. The display device (10) of at least one of claims 6 to 10, wherein a top surface (SS1) of the first intermediate adhesive layer (710) has a round shape convex in the direction toward the cover window (CSUB).

12. The display device (10) of at least one of claims 6 to 11, wherein the top surface (SS1) of the first intermediate adhesive layer (710) contacts the cover window (CSUB).

13. The display device (10) of at least one of claims 6 to 12, wherein the first peripheral adhesive layer (711) and the second peripheral adhesive layer (712) are not in contact with each other.

14. The display device (10) of at least one of claims 1 to 13, further comprising a hole penetrating the adhesive member (ADL), the polarizing layer (POL) and the substrate (SUB), in a display area of the substrate (SUB).

15. The display device (10) of claim 14, wherein an angle (θ3) defined between an inner wall of the hole and the top surface (SS1) of the adhesive member (ADL) is 90 degrees to 135 degrees.

16. The display device (10) of claim 14 or 15, wherein the adhesive member (ADL) comprises:
a second intermediate adhesive layer (910) having a closed curve shape surrounding the hole;
a third peripheral adhesive layer (911) disposed on a first side surface (S10) of the second intermediate adhesive layer (910); and
a fourth peripheral adhesive layer (912) disposed on a second side surface (S20) of the second intermediate adhesive layer (910),
wherein the third peripheral adhesive layer (911) comprises a plurality of third sub-adhesive layers (911a, 911b) having different densities,
wherein the plurality of third sub-adhesive layers (911a, 911b) have higher densities as the plurality of third sub-adhesive layers (911a, 911b) is disposed farther from a center of the second intermediate adhesive layer (910).

17. The display device (10) of claim 16, wherein the first intermediate adhesive layer (710) or the second intermediate adhesive layer (910) has a width which gradually decreases along a direction toward the cover window (CSUB).

18. The display device (10) of claim 16 or 17, wherein the fourth peripheral adhesive layer (912) comprises a plurality of fourth sub-adhesive layers (912a, 912b) having different densities,
wherein the plurality of fourth sub-adhesive layers (912a, 912b) have higher densities as the plurality of fourth sub-adhesive layers (912a, 912b) is disposed farther from a center of the second intermediate adhesive layer (910).

19. An adhesive member (ADL) forming apparatus for a display device, in particular a display device (10) of at least one of claims 1 to 18, the apparatus comprising:
a guide rail (860);
a stage (810) moving along the guide rail (860), on the guide rail (860);
an alignment device (820) which aligns a substrate (SUB) on the stage (810);
a curing device (840) which cures an adhesive member (ADL) of the substrate (SUB);
an inkjet printing device (830) disposed between the alignment device (820) and the curing device (840), and providing a raw material of the adhesive member (ADL) onto the substrate (SUB); and
a printing pattern providing device (850) providing a first printing pattern (PP1) corresponding to an intermediate adhesive layer (710) of the adhesive member (ADL), and a second printing pattern (PP2) corresponding to a first peripheral adhesive layer (711) of the adhesive member (ADL) and a second peripheral adhesive layer (712) of the adhesive member (ADL).

20. An electronic device comprising:
a display device, in particular a display device (10) of at least one of claims 1 to 18, comprising:
a substrate (SUB);
a pixel electrode (PXE) on the substrate (SUB);
a light-emitting layer (EL) on the pixel electrode (PXE);
a common electrode (CE) on the light-emitting layer (EL);
an encapsulation layer (TFE) on the common electrode (CE);
a polarizing layer (POL) on the encapsulation layer (TFE);
an adhesive member (ADL) on the polarizing layer (POL), in particular an adhesive member (ADL) of claim 19;
a cover window (CSUB) on the adhesive member (ADL); and
a light blocking layer (BM) disposed next to the adhesive member (ADL), between the polarizing layer (POL) and the cover window (CSUB),
wherein an angle (θ1) defined between a side surface (SS2) of the adhesive member (ADL) facing the light blocking layer (BM) and a top surface (SS1) of the adhesive member (ADL) facing the cover window (CSUB) is 90 degrees to 135 degrees.
